(19) Europäisches Patentamt
European Patent Office
Office européen des brevets

(11) **EP 4 656 779 A1**

(12) **EUROPEAN PATENT APPLICATION**
published in accordance with Art. 153(4) EPC

(43) Date of publication:
**03.12.2025 Bulletin 2025/49**

(21) Application number: **24759792.5**

(22) Date of filing: **23.02.2024**

(51) International Patent Classification (IPC):
***C30B 29/06*** (2006.01)    ***C30B 15/00*** (2006.01)

(86) International application number:
**PCT/CN2024/078449**

(87) International publication number:
**WO 2024/175120 (29.08.2024 Gazette 2024/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **23.02.2023   CN 202310158796
27.09.2023   CN 202311270249**

(71) Applicant: **Longi Green Energy Technology Co.,
Ltd.
Xi'an, Shaanxi 710100 (CN)**

(72) Inventors:
• **FU, Nannan**
 **Shaanxi 710100 (CN)**
• **WANG, Yichun**
 **Shaanxi 710100 (CN)**

• **BAI, Xueqi**
 **Shaanxi 710100 (CN)**
• **JIN, Qian**
 **Shaanxi 710100 (CN)**
• **LU, Ruochen**
 **Shaanxi 710100 (CN)**
• **FU, Zehua**
 **Shaanxi 710100 (CN)**
• **CHEN, Xiaobo**
 **Shaanxi 710100 (CN)**
• **FAN, Jiarui**
 **Shaanxi 710100 (CN)**
• **MA, Xiaokang**
 **Shaanxi 710100 (CN)**
• **XU, Senyang**
 **Shaanxi 710100 (CN)**

(74) Representative: **Pfenning, Meinig & Partner mbB
Patent- und Rechtsanwälte
Theresienhöhe 11a
80339 München (DE)**

(54) **SILICON WAFER, CELL, CELL STRING, AND SOLAR MODULE**

(57)    This application relates to a silicon wafer, where a concentration of an antimony element in the silicon wafer ranges from $4E+14$ cm$^{-3}$ to $2E+16$ cm$^{-3}$, preferably ranges from $4.30E+14$ cm$^{-3}$ to $1.9E+16$ cm$^{-3}$, and further preferably ranges from $4.45E+14$ cm$^{-3}$ to $1.87E+16$ cm$^{-3}$; and a minority carrier lifetime of the silicon wafer is greater than or equal to 200 μs, preferably greater than or equal to 300 μs, and further preferably greater than or equal to 500 μs. This application further relates to another silicon wafer, where a concentration of an antimony element in the silicon wafer ranges from $4E+14$ cm$^{-3}$ to $2E+16$ cm$^{-3}$, preferably ranges from $4.30E+14$ cm$^{-3}$ to $1.9E+16$ cm$^{-3}$, and further preferably ranges from $4.45E+14$ cm$^{-3}$ to $1.87E+16$ cm$^{-3}$; and a minority carrier lifetime of the silicon wafer is greater than or equal to 300 μs, preferably greater than or equal to 400 μs, and further preferably greater than or equal to 600 μs.

FIG. 1

EP 4 656 779 A1

**Description**

**CROSS-REFERENCE TO RELATED APPLICATIONS**

This application claims priorities to Chinese Patent Application No. 202310158796.2, field with the China National Intellectual Administration Property on February 23, 2023 and entitled "MONOCRYSTALLINE SILICON INGOT AND SILICON WAFER PREPARED THEREFROM, CELL, AND CELL MODULE", and Chinese Patent Application No. 202311270249.X, filed with the China National Intellectual Administration Property on September 27, 2023 and entitled "LONG-LIFETIME SILICON WAFER AND SILICON WAFER GETTERING METHOD", which are incorporated herein by reference in their entities.

**TECHNICAL FIELD**

This application relates to the solar photovoltaic field, specifically relates to a silicon wafer, and relates to a cell, a cell string, and a solar module that include the silicon wafer.

**BACKGROUND**

With the increasing exhaustion of conventional energy sources, and increasing requirements of people for the environment, as a pollution-free clean energy source, solar cells develop more rapidly. However, a preparation technology of crystalline silicon solar cells that nowadays occupy most of the market of solar cells represents the level of the entire solar cell industry.

A working principle of a solar cell is: When sunlight is shed on the solar cell, the cell absorbs the optical energy, to generate photogenerated electron-hole pairs. Under the action of a built-in electric field of the cell, photogenerated electrons and holes are separated, and charges of different signs are accumulated at two ends of the photovoltaic cell, that is, a "photogenerated voltage" is generated, which is a "photogenerated volt effect". If electrodes are led out and a load is connected on two sides of the built-in electric field, a "photogenerated current" flows in the load, thereby obtaining power output. In this way, the optical energy of the sun directly becomes practical electric energy.

The most important performance of the solar cell is the photoelectric conversion efficiency, and there is a close relationship between the length of the minority carrier lifetime of the silicon wafer and the conversion efficiency. To achieve higher photoelectric conversion efficiency, a silicon wafer having a higher minority carrier lifetime is needed.

**SUMMARY**

Because a currently developed silicon wafer still cannot satisfy a requirement in the photovoltaic field for a long-lifetime silicon wafer, new materials still need to be further developed in the field to further prolong the lifetime of the silicon wafer. The applicant of this application has intensively researched to obtain a silicon wafer whose minority carrier lifetime is significantly longer than that of the silicon wafer in the existing technology. Specifically, this application relates to the following content:

This application provides a silicon wafer, where a concentration of an antimony element in the silicon wafer ranges from $4E+14$ $cm^{-3}$ to $2E+16$ $cm^{-3}$, preferably ranges from $4.30E+14$ $cm^{-3}$ to $1.9E+16$ $cm^{-3}$, and further preferably ranges from $4.45E+14$ $cm^{-3}$ to $1.87E+16$ $cm^{-3}$; and

a minority carrier lifetime of the silicon wafer is greater than or equal to 200 $\mu$s, preferably greater than or equal to 300 $\mu$s, and further preferably greater than or equal to 500 $\mu$s.

In this application, the minority carrier lifetime of the silicon wafer is combined with the doping concentration of the antimony element, and the doping concentration of the antimony element is controlled to fall within a target range. Therefore, the minority carrier lifetime of the silicon wafer is relatively long, which helps improve cell efficiency.

Optionally, the minority carrier lifetime of the silicon wafer is greater than or equal to 1000 $\mu$s, preferably greater than or equal to 3000 $\mu$s, and further preferably greater than or equal to 5000 $\mu$s.

This application further provides a silicon wafer, the silicon wafer is obtained by performing gettering treatment on a silicon substrate containing an antimony element, and the gettering treatment is preferably tube-type gettering treatment or chain-type gettering treatment;

a concentration of an antimony element in the silicon wafer ranges from $4E+14$ $cm^{-3}$ to $2E+16$ $cm^{-3}$, preferably ranges from $4.30E+14$ $cm^{-3}$ to $1.9E+16$ $cm^{-3}$, and further preferably ranges from $4.45E+14$ $cm^{-3}$ to $1.87E+16$ $cm^{-3}$; and
a minority carrier lifetime of the silicon wafer is greater than or equal to 300 $\mu$s, preferably greater than or equal to 400 $\mu$s, and further preferably greater than or equal to 600 $\mu$s.

The antimony-doped monocrystalline silicon wafer of this application is used. Further, through the gettering process, the minority carrier lifetime of the silicon wafer is further prolonged. Compared with a conventional phosphorus-doped single crystal, the minority carrier lifetime of the antimony-doped silicon wafer on which gettering is performed is more significantly prolonged. In addition, after gettering, a cell prepared by using the antimony-doped monocrystalline silicon wafer has a significant short-circuit current improvement and a slight open-circuit voltage improvement.

Optionally, the minority carrier lifetime of the silicon wafer is greater than or equal to 1200 $\mu$s, preferably greater than or equal to 3300 $\mu$s, and further preferably greater than or equal to 5500 $\mu$s.

Optionally, a resistivity of the silicon wafer ranges from 0.3 to 10 $\Omega\cdot$cm, preferably ranges from 0.4 to 8 $\Omega\cdot$cm, and further preferably ranges from 0.5 to 6 $\Omega\cdot$cm.

In this application, by controlling the doping concentration distribution of the foregoing silicon wafer, the concentration of resistivities of the silicon wafer is increased. For the cell, first, more stable and reliable cell performance can be provided, and a consistent resistivity can ensure a similar condition of each component during operation, thereby reducing an energy loss and an efficiency loss. Second, higher cell efficiency can be provided, and a consistent resistivity enables the cell to better distribute and transmit electric energy during operation, thereby reducing an electric energy loss, and improving energy conversion efficiency of the cell. This can prolong the use time of the cell, reduce the number of times of charging, and improve the energy efficiency of the entire system. Third, a heat loss of the cell can be further reduced. The cell generates some heat during operation, and the heat loss reduces efficiency of the cell.

Optionally, the silicon wafer further includes at least one of phosphorus, gallium, and germanium.

In this application, when the silicon wafer includes phosphorus, because of a difference between an evaporation rate of antimony and that of phosphorus in a doping procedure, in a late stage of crystal pulling, only a single dopant phosphorus is in effect, so that the head and the tail of an ingot have relatively close resistivities, thereby improving the uniformity of axial resistivities, and correspondingly also improving the uniformity of resistivities in the silicon wafer. When the silicon wafer includes gallium, longitudinal resistivity distribution of a prepared monocrystalline silicon ingot is more uniform, so that the length of the monocrystalline silicon ingot during production can be increased, and then resistivity uniformity in a silicon wafer prepared by cutting the silicon ingot is also improved. When the silicon wafer includes germanium, native micro-defects, especially void defects, in the monocrystalline silicon can be suppressed through effects of germanium and point defects (self-interstitial silicon atoms and vacancies), so that quality and a yield of the monocrystalline silicon can be effectively improved, and native defects can be suppressed, to improve quality of the crystal.

Optionally, a side length of the silicon wafer is greater than 156 mm.

In this application, because the doping concentration of the silicon wafer is controlled, so that the uniformity of radial resistivities of the silicon wafer is good, and a large-sized silicon wafer can be prepared. For a same-sized silicon wafer, a ratio of the minority carrier lifetime to the resistivity of the silicon wafer in this application is relatively high. For example, a side length of the foregoing large-sized silicon wafer is greater than or equal to 156 mm.

Optionally, the silicon wafer is a rectangle, one side length of the rectangle ranges from 156 mm to 300 mm, and the other side length of the rectangle ranges from 83 to 300 mm.

In this application, because the silicon wafer or the silicon substrate (including a stripped partial silicon substrate recovered and stripped from another layer structure) is set to be rectangular, the rectangular silicon wafer in this application may be a rectangular slice obtained after a silicon ingot is machined and sliced, or may be a rectangular slice obtained after a square/rectangular silicon wafer is sliced/half-cut. The rectangular silicon wafer or the silicon substrate has one side length controlled to range from 156 mm to 300 mm, and the other side length controlled to range from 83 mm to 300 mm. Compared with a square cell, the area of the rectangular cell is larger. Therefore, the area that can be used for receiving light is also larger, thereby having higher photoelectric conversion efficiency. In addition, after being laid out, the cells provided in this embodiment of this application are more convenient to be transferred, which helps improve container utilization, thereby improving transfer efficiency.

Optionally, the silicon wafer further includes a chamfer connected between two adjacent sides of the silicon wafer, and a projection length of an arc length of the chamfer ranges from 1 mm to 10 mm.

In this application, the silicon wafer is provided with a chamfer, which further helps reduce damage of the silicon wafer in transfer and machining procedures, improves a yield of a subsequent operation, reduces a fragmentation rate, and reduces waste of production costs.

Optionally, a thickness of the silicon wafer ranges from 40 $\mu$m to 170 $\mu$m, preferably ranges from 70 $\mu$m to 160 $\mu$m, and further preferably ranges from 80 $\mu$m to 140 $\mu$m.

In this application, by setting the thickness of the silicon wafer to range from 40 to 170 $\mu$m, first, the silicon wafer has relatively high strength, and the fragmentation rate of the silicon wafer is reduced, which helps prolong the service life of the silicon wafer; and second, if the thickness of the silicon wafer ranges from 60 to 140 $\mu$m, the silicon wafer is easy to be machined, production capacity is large, and the production costs can be reduced. That is, controlling the silicon wafer to fall within a relatively small thickness range also helps reduce the production costs of the silicon wafer.

Optionally, the concentration of the antimony element in the silicon wafer and a relative impurity level in the silicon wafer satisfy the following formula (1):

$$\frac{n_0 + a}{\tau_{SRH} \times b \times (n_0 + c)} \le 5E-1 \quad (1)$$

where $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of cm$^{-3}$, cm/s, and cm$^{-3}$ respectively;

preferably, the concentration of the antimony element in the silicon wafer and a relative impurity level in the silicon wafer satisfy the following formula (2):

$$\frac{n_0 + a}{\tau_{SRH} \times b \times (n_0 + c)} \le 9E-2 \quad (2);$$

and further preferably, the concentration of the antimony element in the silicon wafer and a relative impurity level in the silicon wafer satisfy the following formula (3):

$$5E-5 \le \frac{n_0 + a}{\tau_{SRH} \times b \times (n_0 + c)} \le 6E-2 \quad (3);$$

where a is any value selected from 3.5E+18 to 5.5E+18, a is further preferably any value from 4E+18 to 5E+18, and a is further preferably 4.54E+18; b is any value selected from 0.8E+7 to 1.5E+7, b is further preferably any value from 0.9E+7 to 1.3E+7, and b is further preferably 1.1E+7; and c is any value selected from 1E+15 to 9E+15, c is further preferably any value from 1E+15 to 7E+15, and c is further preferably 3E+15.

In this application, for the silicon wafer satisfying the foregoing formula (1), formula (2), or formula (3), because a concentration of an impurity in the silicon wafer is controlled to fall within a particular range, a relatively long minority carrier lifetime of the silicon wafer can be achieved.

Optionally, the concentration of the antimony element in the silicon wafer and a relative impurity level in the silicon wafer satisfy the following formula (1'):

$$\frac{n_0 + a}{\tau_{SRH} \times b \times (n_0 + c)} \le 1E-1 \quad (1')$$

where $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of cm$^{-3}$, cm/s, and cm$^{-3}$ respectively;

preferably, the concentration of the antimony element in the silicon wafer and a relative impurity level in the silicon wafer satisfy the following formula (2'):

$$\frac{n_0 + a}{\tau_{SRH} \times b \times (n_0 + c)} \le 8E-2 \quad (2');$$

and further preferably, the concentration of the antimony element in the silicon wafer and a relative impurity level in the silicon wafer satisfy the following formula (3'):

$$4E-5 \le \frac{n_0 + a}{\tau_{SRH} \times b \times (n_0 + c)} \le 5E-2 \quad (3').$$

This application further provides a cell, including a silicon substrate, where a doped region is provided inside a surface of at least one side of the silicon substrate, the silicon substrate contains an antimony element, the doped region is doped with a doping element, and the doping element is selected from Group IIIA elements or Group VA elements;

a doping concentration of the antimony element in the silicon substrate ranges from 4E+14 cm$^{-3}$ to 2E+16 cm$^{-3}$, preferably ranges from 4.3E+14 cm$^{-3}$ to 1.9E+16 cm$^{-3}$, and further preferably ranges from 4.45E+14 cm$^{-3}$ to 1.87E+16

cm$^{-3}$; and

a minority carrier lifetime of the silicon substrate is greater than or equal to 200 μs, preferably greater than or equal to 300 μs, and further preferably greater than or equal to 500 μs.

In this application, because the concentration of the antimony element is properly controlled in the foregoing silicon wafer, to implement uniform doping, the resistivity of the silicon wafer or the bare silicon wafer is uniform. Using such a silicon wafer to prepare a cell can reduce the transverse transfer resistance of carriers, thereby finally improving the efficiency of the cell. In addition, by using the silicon wafer of this application, a minority carrier lifetime of the silicon wafer is relatively long to facilitate carrier migration, a short-circuit current of a prepared cell is improved, and cell efficiency is further improved.

Optionally, a doped region is provided inside a surface of at least one side of the silicon substrate, or at least one doped passivation layer is provided on a surface of at least one side of the silicon substrate.

Lattice distortion is caused due to single-element doping. Generally, lattice distortion of crystalline silicon is caused due to single-element doping to cause many defects in a heavily-doped region. In this application, the antimony Atoms in the antimony-doped silicon wafer can capture and neutralize defects caused by radiation, thereby reducing the formation and diffusion of the defects. Therefore, a cell made from the antimony-doped silicon wafer generally has better radiation stability than that made from the phosphorus-doped silicon wafer.

Optionally, the doping concentration of the antimony element in the doped region is substantially unchanged in a thickness direction of the silicon substrate.

Therefore, the lattice distortion of crystalline silicon caused by single-element doping in the silicon substrate to cause many defects in a heavily-doped region can be overcome, and light absorption can be further improved, thereby improving the cell efficiency.

Optionally, in the doped region, a sum of the doping concentration of the antimony element and a doping concentration of the doping element is less than or equal to 1E+21 cm$^{-3}$.

According to the cell of this application, because a range of a sum of a concentration in a doped region and a concentration of a doping element is controlled, carrier separation is facilitated, carrier recombination is reduced, and a short-circuit current and an open-circuit voltage are increased.

Optionally, when the doping element is a Group IIIA element, a thickness range of the doped region is from 30 to 650 nm; or

when the doping element is a Group VA element, a thickness range of the doped region is from 100 to 200 nm.

Optionally, the doped region includes a first doped region and a second doped region;

an interfacial passivation layer and a doped passivation layer are sequentially stacked on a surface of a side of the first doped region away from the silicon substrate;

the doped passivation layer is doped with a first doping element;

the second doped region on the silicon substrate is further doped with a second doping element; and

a conduction type of the first doped region is opposite to that of the second doped region.

In actual application, lattice distortion is caused due to single-element doping. Generally, lattice distortion of crystalline silicon is caused due to single-element doping to cause many defects in a heavily-doped region. In this application, two doped regions are disposed, the doped passivation layer is doped with the first doping element, and the second doped region on the silicon substrate is further doped with the second doping element, so that the cell of this application can effectively prevent occurrence of lattice distortion.

Optionally, the first doping element is a Group VA element, and the second doping element is a Group IIIA element; and

in the doped passivation layer, a doping concentration of the first doping element at a first preset depth from the surface of the doped passivation layer away from the silicon substrate is greater than a doping concentration of the second doping element at an identical first preset depth from the surface of the second doped region, a thickness range of the doped passivation layer is from 100 to 400 nm, and the first preset depth is less than or equal to a thickness of the doped passivation layer.

In this manner, because the concentration of the first doping element is greater than the concentration of the second doping element, Auger recombination of free carriers can be further reduced, and the short-circuit current can be further improved. In another aspect, Auger recombination of free carriers can be reduced without reducing a passivation effect of a tunneling layer, thereby further improving the short-circuit current, the open-circuit voltage, and the cell efficiency.

Optionally, the first doping element is a Group VA element, and the second doping element is a Group IIIA element; and

an interfacial passivation layer and a doped passivation layer are sequentially stacked on a surface of a side of the second doped region away from the silicon substrate; and

in the doped passivation layer, a doping concentration of the first doping element at a first preset depth from the surface of the doped passivation layer away from the silicon substrate in the first doped region is greater than a doping concentration of the second doping element at an identical first preset depth from the surface of the doped passivation layer away from the silicon substrate in the second doped region, a thickness range of the doped passivation layer on the first doped region is from 100 to 400 nm, a thickness range of the doped passivation layer on the second doped region is from 100 to 400 nm, and the first preset depth is less than or equal to a thickness of the doped passivation layer on the first doped region.

In this application, thickness ranges of the doped passivation layers on the first doped region and the second doped region are controlled to be from 100 to 400 nm, to further reduce Auger recombination of free carriers, and further improve the short-circuit current.

Optionally, the interfacial passivation layer is doped with a first doping element; and

in a direction from the doped passivation layer to the interfacial passivation layer, in the interfacial passivation layer, a doping concentration of the first doping element at a second preset depth from the surface of the doped passivation layer away from the silicon substrate is greater than a doping concentration of the second doping element at an identical second preset depth from the surface of the second doped region, a thickness range of the interfacial passivation layer is from 0.5 to 3 nm, and the second preset depth is less than or equal to a sum of thicknesses of the doped passivation layer and the interfacial passivation layer.

In this application, the thickness range of the interfacial passivation layer is controlled to be from 0.5 to 3 nm, to help reduce Auger recombination of free carriers, and further improve the short-circuit current. In addition, because the concentration of the first doping element is greater than the concentration of the second doping element, Auger recombination of free carriers can be further reduced, and the short-circuit current can be further improved.

Optionally, the interfacial passivation layer of the first doped region is doped with a first doping element, and the interfacial passivation layer of the second doped region is doped with a second doping element; and

in a direction from the doped passivation layer to the interfacial passivation layer, in the interfacial passivation layer, a doping concentration of the first doping element at a second preset depth from the surface of the doped passivation layer away from the silicon substrate in the first doped region is greater than a doping concentration of the second doping element at an identical second preset depth from the surface of the doped passivation layer away from a silicon matrix in the second doped region, a thickness range of the interfacial passivation layer on the first doped region is from 0.5 to 3 nm, a thickness range of the interfacial passivation layer on the second doped region is from 0.5 to 3 nm, and the second preset depth is less than or equal to a sum of thicknesses of the doped passivation layer and the interfacial passivation layer on the first doped region.

Optionally, in a direction from the doped passivation layer to a surface of the first doped region, in the silicon substrate, a doping concentration of the first doping element at a third preset depth from the surface of the doped passivation layer away from a silicon matrix is greater than a doping concentration of the second doping element at an identical third preset depth from the surface of the second doped region, a thickness range of the first doped region is from 30 to 100 nm, and the third preset depth is less than or equal to a sum of thicknesses of the doped passivation layer, the interfacial passivation layer, and the first doped region.

Optionally, in a direction from the doped passivation layer to a surface of the first doped region, in a silicon matrix, a doping concentration of the first doping element at a third preset depth from the surface of the doped passivation layer away from the silicon substrate in the first doped region is greater than a doping concentration of the second doping element at an identical third preset depth from the surface of the doped passivation layer away from the silicon matrix in the second doped region, a thickness range of the first doped region is from 30 to 100 nm, and the third preset depth is less than or equal to a sum of thicknesses of the doped passivation layer and the interfacial passivation layer on the first doped region, and the first doped region.

Optionally, when the doping element is a Group IIIA element, a thickness range of the doped region is from 80 to 180 nm; or

when the doping element is a Group VA element, a thickness range of the doped region is from 30 to 100 nm.

In this application, the large-sized antimony Atoms cause a lattice distortion phenomenon, but play a role in suppressing vacancy defects; and the doping concentration of the antimony element is controlled to fall within the foregoing range, so that the large-sized antimony atoms after being added can play a role in reducing the concentration of vacancy defects and reducing the formation of oxygen precipitation.

Optionally, the cell includes an electrode formed on a light absorbing body, the electrode includes a metallic crystal part in contact with the light absorbing body, and the metallic crystal part includes the antimony element, where the light absorbing body includes the silicon substrate and a region for separating carriers generated by the silicon substrate.

Because the metallic crystal part of the electrode of the cell of this application contains the antimony element, contact resistance of the cell can be reduced and the contact resistance of the cell can be further reduced.

Optionally, the metallic crystal part further includes a doping element, and a doping concentration of the doping element is greater than a doping concentration of the antimony element.

By controlling the concentration of the antimony element to fall within the foregoing range, the carrier recombination effect can be reduced, the self-doping effect of the antimony element can be reduced, original and expected features of structural layers of the cell can be maintained, and good film layer quality can be achieved, which helps improve the conversion efficiency of the cell.

Other aspects and advantages of this application will be given in the following description, some of which will become apparent from the following description or may be learned from practices of this application.

## BRIEF DESCRIPTION OF THE DRAWINGS

To describe technical schemes in embodiments of this application or the existing technology more clearly, the following briefly introduces accompanying drawings required for describing the embodiments or the existing technology. Apparently, the accompanying drawings in the following descriptions show some of the embodiments of this application, and a person of ordinary skill in the art still derives other drawings from these accompanying drawings without creative efforts.

FIG. 1 is a schematic diagram of a cell structure (a TOPCon structure) according to this application.
FIG. 2 is a schematic diagram of a cell stringing procedure.
FIG. 3 is another schematic diagram of a cell stringing procedure.
FIG. 4 is a specific schematic structural diagram of a cell module.
FIG. 5 is another specific schematic structural diagram of a cell module.
FIG. 6 is a schematic diagram of comparison between defect concentrations of an antimony-doped silicon ingot and a phosphorus-doped silicon ingot in a pulling procedure.

## DETAILED DESCRIPTION

To make the objectives, technical solutions, and advantages of the embodiments of this application clearer, the following clearly and completely describes the technical solutions in the embodiments of this application with reference to the accompanying drawings in the embodiments of this application. Apparently, the described embodiments are some rather than all of the embodiments of this application. All other embodiments obtained by a person of ordinary skill in the art based on the embodiments of this application without creative efforts shall fall within the protection scope of this application.

Features of terms such as "first" and "second" in this specification and the claims of this application may explicitly indicate or implicitly include one or more features. In the description of this application, unless otherwise stated, "a plurality of" means two or more than two. In addition, in this specification and the claims "and/or" generally indicates at least one of connected objects, and the character "/" generally indicates an "or" relationship between associated objects.

In the description of the present disclosure, it should be understood that orientation or position relationships indicated by the terms such as "center", "longitudinal", "transverse", "length", "width", "thickness", "up", "down", "front", "rear", "left", "right", "vertical", "horizontal", "top", "bottom", "inside", "outside", "clockwise", "counterclockwise", "axial direction", "radial direction", and "circumferential direction" are based on orientation or position relationships shown in the drawings, and are used only for ease and brevity of description of the present disclosure, rather than indicating or implying that the mentioned apparatus or element needs to have a particular orientation or needs to be constructed and operated in a particular orientation. Therefore, such terms should not be construed as a limitation on the present disclosure.

In the descriptions of this application, it should be noted that, unless otherwise explicitly specified and defined, the terms such as "mount", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two elements. A person of ordinary skill in the art can understand specific meanings of the terms in this application based on specific situations.

In this application, the concentration of the antimony element in the silicon wafer or the silicon substrate may be detected by using any method known by a person skilled in the art, and may be selected by the person skilled in the art based on a requirement. For example, the concentration may be detected by using a method such as SIMS, ICP-MS, or GDMS, and preferably detected by using an ICP-MS method. A person skilled in the art may understand that the concentration of the antimony element in the silicon wafer may refer to a concentration of the antimony element at any site on the surface of the silicon wafer, in the silicon wafer, or in the middle of the silicon wafer, and certainly, may alternatively be an average value of concentrations of the antimony element at a plurality of positions (for example, concentrations at positions such as a midpoint and an edge) or an average value of concentrations of the antimony element on the entire silicon wafer. A person skilled in the art may select the foregoing any site for detection based on a detection condition and a used instrument and based on an actual situation, or may calculate an average value of a plurality of sites after detecting the plurality of sites and use the average value as the concentration of the antimony element.

In this application, the resistivity of the silicon wafer or the silicon substrate may be detected by using any method known by a person skilled in the art, and may be selected by the person skilled in the art based on a requirement. For example, the resistivity may be detected by using a four-probe tester, or may be detected by using a method such as a non-contact eddy current method (for example, from a terahertz offline two-dimensional imaging device). In a specific manner, the resistivity is detected by using a four-probe tester. A person skilled in the art may understand that the resistivity of the silicon wafer may refer to resistivity detection data of any site on the surface of the silicon wafer or in the middle of the silicon wafer, and certainly may alternatively be an average value of resistivity detection data of a plurality of positions or an average value of resistivities of the entire silicon wafer. A person skilled in the art may select the foregoing any site for detection based on a detection condition and a used instrument and based on an actual situation, or may calculate an average value of a plurality of sites after detecting the plurality of sites and use the average value as the resistivity of the silicon wafer.

In this application, during detection of the foregoing antimony concentration or resistivity, if a person skilled in the art needs to select a plurality of sites to calculate an average value, the person may randomly select, for example, randomly select at least 2 sites, 3 sites, 4 sites, 5 sites, 6 sites, 7 sites, 8 sites, 9 sites, or 10 sites on a silicon ingot or a silicon wafer or a silicon substrate to perform detection and calculation.

In this application, the minority carrier lifetime of the silicon wafer or the silicon substrate may be detected by using any method known by a person skilled in the art, for example, may be detected by using a BCT-400 instrument, a WCT-120 instrument, or a WT-2000 instrument. During detection, a carrier injection level needs to be set to 1E+15 to 3E+15, and a minority carrier lifetime at the injection level is measured. However, a person skilled in the art can completely understand that the injection levels (1E+15 to 3E+15) listed above are merely a set range, and if the injection levels are set to another range, the injection levels may be converted.

A specific conversion method may be, for example, the following method: first, setting a carrier injection level to perform a minority carrier lifetime test, to obtain an injection level-minority carrier lifetime curve in which a horizontal coordinate is the injection level and a vertical coordinate is the minority carrier lifetime. By using the curve, a minority carrier lifetime in another carrier injection condition (for example, a carrier injection level such as 5E14 is used) may be converted into a minority carrier lifetime at a carrier injection level of 1E+15 to 3E+15.

In this application, the minority carrier lifetime is detected as a minority carrier lifetime obtained at a carrier injection level of 1E+15 to 3E+15 (including a minority carrier lifetime calculated when another carrier injection level is converted to an injection level of 1E+15 to 3E+15).

In this application, a method for detecting whether a silicon wafer or a silicon substrate contains an impurity may be performed by using a method such as SIMS, ICP-MS, or GDMS. Preferably, a metal impurity is detected by using an ICP-MS method.

In this application, for a test method of mechanical strength of a silicon wafer, refer to a fine ceramics bending strength test method GB/T 6569-2006. In the used test method, the bending strength refers to the maximum stress of a material when the material breaks under a bending load condition. In this application, the curvature of the cell may also be detected by using the method.

In this application, a dispersion degree of mechanical strengths of silicon wafers is used for representing strength uniformity of different silicon wafers prepared by using a same process. A lower dispersion degree indicates a smaller strength difference between different silicon wafers. Detection may be performed by using a test method known in the art. For example, the dispersion degree of mechanical strengths of silicon wafers is tested by using a single-column electronic universal testing machine.

In this application, the side length or the thickness of the silicon wafer may be detected by using a length or thickness measuring method known in the art, for example, may be measured by using a micrometer.

In this application, the projection length of the arc length of the chamfer connected between two adjacent sides of the silicon wafer may also be detected by using a length measuring method commonly used by a person skilled in the art, for example, may be measured by using a micrometer.

A person skilled in the art may understand that a silicon wafer usually refers to a bare silicon wafer as a raw material, and a silicon substrate usually refers to a part formed by a silicon wafer in a cell. The light absorbing body generally refers to a functional body that is in a cell and that is used for absorbing photons, generating photogenerated carriers, and separating the photogenerated carriers. The light absorbing body includes a silicon substrate and a region (for example, a tunneling layer and a doped polycrystalline layer in a TOPCon structure) for separating carriers generated by the silicon substrate. The silicon substrate is used for absorbing light and generating photogenerated carriers. It may be understood that a pure emission reduction layer, another functional layer, and an electrode do not belong to the light absorbing body. A person skilled in the art may understand that the light absorbing body or the silicon substrate may be recovered from the cell, and the silicon substrate defined in this application may be obtained by striping different stack structures.

In this application, the doped region may also be used for separating photogenerated carriers, and is, for example, a region in which a Group IIIA element (a boron element) is diffused in the following TOPCon cell.

That is, the silicon substrate is obtained from a bare silicon wafer. The silicon substrate includes a silicon matrix and a doped region. The silicon matrix is a bulk region that is not doped in a cell process, and has performance the same as that of a bare silicon wafer as a raw material. Except being different in doping elements, the doped region may have other performance and parameters that are substantially the same as those of the bulk region, and is, for example, a doped region formed through direct doping or internal diffusion doping in the bare silicon wafer. In addition, in some cases, the doped region is a place where an antimony element or a doping element such as a Group IIIA element or a Group VA element, specifically for example, B or P is accumulated. In some cases, the doped region may be substantially the same as the bulk region, that is, mainly includes an antimony element doped region.

For at least some cells having a TOPCon structure (for example, a TOPCon cell, a partial TOPCon cell, a back-contact hybrid cell, and a TBC cell), a silicon substrate usually includes a doped region formed inside a surface of at least one side of the silicon substrate, and performance of the doped region is the same as that of a bare silicon wafer as a raw material. Except being different in doping elements, the doped region may have other performance and parameters, that is, properties such as the concentration of the antimony element, the resistivity change rate, and the resistivity offset rate, that are substantially the same as those of the bulk region. Such a doped region may be formed by directly doping a bare silicon wafer, which is described in detail below, or may be formed, for example, by doping a bare silicon wafer with a doping element through layers such as a doped passivation layer and an interfacial passivation layer. In this application, for at least some cells having the TOPCon structure, the doped region usually refers to a region formed by direct doping or internal diffusion doping in the raw material silicon wafer, where the internal diffusion doping is formed by entering the bare silicon wafer through a doped polycrystalline silicon layer referred to as a doped layer and a tunneling layer referred to as a passivation layer.

In a case of a crystal silicon heterojunction (HJT/HIT) cell or a full-back electrode heterojunction back-contact (HBC) cell, the doped region also refers to a doped region inside an inner surface of at least one side of the silicon substrate. In this case, the doped region is a place where an antimony element or a doping element such as a Group IIIA element or a Group VA element, specifically for example, B or P is accumulated, or the doped region may be substantially the same as the bulk region, that is, mainly includes an antimony element doped region. Further, a doped amorphous silicon layer as a doped layer and an intrinsic amorphous silicon layer as a passivation layer are provided on a surface of at least one side of the silicon substrate. In this case, the doping element may or may not enter the raw material silicon wafer.

In this application, the foregoing silicon wafer involved in this application is not further limited, and may be a silicon wafer (which may also be referred to as a bare silicon wafer) obtained after a silicon ingot is pulled and then machined and sliced. The silicon substrate in this application may be a partial silicon substrate that is stripped and recovered from the cell module, provided that the silicon substrate can have a particular shape and can present a sheet shape, that is, have a size on one surface greater than a size of a surface perpendicular to the one surface, and have a flat shape or a sheet shape. The size of the silicon wafer or the silicon substrate in this application is not limited either. The silicon wafer or the silicon substrate may be of any size. From the cell module, a light absorbing body is recovered and a stripped partial silicon substrate of another layer structure is stripped. In addition, a person skilled in the art may understand that during striping, if a part of the doped region is damaged, as long as a part of the doped region that should also be understood as the silicon substrate described in this application still exists, a cell having such a silicon substrate is also a cell satisfying the definition of this application.

This application provides a first silicon wafer, where a concentration of an antimony element in the silicon wafer ranges from $4E{+}14$ cm$^{-3}$ to $2E{+}16$ cm$^{-3}$, and a minority carrier lifetime of the silicon wafer is greater than or equal to 200 $\mu$s.

In this application, the minority carrier lifetime of the silicon wafer is combined with the doping concentration of the antimony element, and the doping concentration of the antimony element is controlled to fall within a target range, which helps improve cell efficiency while prolonging the minority carrier lifetime.

The concentration of the antimony element in the silicon wafer may be, for example, $4E{+}14$ cm$^{-3}$, $4.1E{+}14$ cm$^{-3}$, $4.2E{+}14$ cm$^{-3}$, $4.3E{+}14$ cm$^{-3}$, $4.4E{+}14$ cm$^{-3}$, $4.5E{+}14$ cm$^{-3}$, $4.6E{+}14$ cm$^{-3}$, $4.7E{+}14$ cm$^{-3}$, $4.8E{+}14$ cm$^{-3}$, $4.9E{+}14$ cm$^{-3}$, $5E{+}14$ cm$^{-3}$, $5.1E{+}14$ cm$^{-3}$, $5.2E{+}14$ cm$^{-3}$, $5.3E{+}14$ cm$^{-3}$, $5.4E{+}14$ cm$^{-3}$, $5.5E{+}14$ cm$^{-3}$, $5.6E{+}14$ cm$^{-3}$, $5.7E{+}14$ cm$^{-3}$, $5.8E{+}14$ cm$^{-3}$, $5.9E{+}14$ cm$^{-3}$, $6E{+}14$ cm$^{-3}$, $6.1E{+}14$ cm$^{-3}$, $6.2E{+}14$ cm$^{-3}$, $6.3E{+}14$ cm$^{-3}$, $6.4E{+}14$ cm$^{-3}$, $6.5E{+}14$ cm$^{-3}$, $6.6E{+}14$ cm$^{-3}$, $6.7E{+}14$ cm$^{-3}$, $6.8E{+}14$ cm$^{-3}$, $6.9E{+}14$ cm$^{-3}$, $7E{+}14$ cm$^{-3}$, $7.1E{+}14$ cm$^{-3}$, $7.2E{+}14$ cm$^{-3}$, $7.3E{+}14$ cm$^{-3}$, $7.4E{+}14$ cm$^{-3}$, $7.5E{+}14$ cm$^{-3}$, $7.6E{+}14$ cm$^{-3}$, $7.7E{+}14$ cm$^{-3}$, $7.8E{+}14$ cm$^{-3}$, $7.9E{+}14$ cm$^{-3}$, $8E{+}14$ cm$^{-3}$, $8.1E{+}14$ cm$^{-3}$, $8.2E{+}14$ cm$^{-3}$, $8.3E{+}14$ cm$^{-3}$, $8.4E{+}14$ cm$^{-3}$, $8.5E{+}14$ cm$^{-3}$, $8.6E{+}14$ cm$^{-3}$, $8.7E{+}14$ cm$^{-3}$, $8.8E{+}14$ cm$^{-3}$, $8.9E{+}14$ cm$^{-3}$, $9E{+}14$ cm$^{-3}$, $9.1E{+}14$ cm$^{-3}$, $9.2E{+}14$ cm$^{-3}$, $9.3E{+}14$ cm$^{-3}$, $9.4E{+}14$ cm$^{-3}$, $9.5E{+}14$ cm$^{-3}$, $9.6E{+}14$ cm$^{-3}$, $9.7E{+}14$ cm$^{-3}$, $9.8E{+}14$ cm$^{-3}$, $9.9E{+}14$ cm$^{-3}$, $1E{+}15$ cm$^{-3}$, $1.1E{+}15$ cm$^{-3}$, $1.2E{+}15$ cm$^{-3}$, $1.3E{+}15$ cm$^{-3}$, $1.4E{+}15$ cm$^{-3}$, $1.5E{+}15$ cm$^{-3}$, $1.6E{+}15$ cm$^{-3}$, $1.7E{+}15$ cm$^{-3}$, $1.8E{+}15$ cm$^{-3}$, $1.9E{+}15$ cm$^{-3}$, $2E{+}15$ cm$^{-3}$, $2.1E{+}15$ cm$^{-3}$, $2.2E{+}15$ cm$^{-3}$, $2.3E{+}15$ cm$^{-3}$, $2.4E{+}15$ cm$^{-3}$, $2.5E{+}15$ cm$^{-3}$, $2.6E{+}15$ cm$^{-3}$, $2.7E{+}15$ cm$^{-3}$, $2.8E{+}15$ cm$^{-3}$, $2.9E{+}15$ cm$^{-3}$, $3E{+}15$ cm$^{-3}$, $3.1E{+}15$ cm$^{-3}$,

3.2E+15 cm$^{-3}$, 3.3E+15 cm$^{-3}$, 3.4E+15 cm$^{-3}$, 3.5E+15 cm$^{-3}$, 3.6E+15 cm$^{-3}$, 3.7E+15 cm$^{-3}$, 3.8E+15 cm$^{-3}$, 3.9E+15 cm$^{-3}$, 4E+15 cm$^{-3}$, 4.1E+15 cm$^{-3}$, 4.2E+15 cm$^{-3}$, 4.3E+15 cm$^{-3}$, 4.4E+15 cm$^{-3}$, 4.5E+15 cm$^{-3}$, 4.6E+15 cm$^{-3}$, 4.7E+15 cm$^{-3}$, 4.8E+15 cm$^{-3}$, 4.9E+15 cm$^{-3}$, 5E+15 cm$^{-3}$, 5.1E+15 cm$^{-3}$, 5.2E+15 cm$^{-3}$, 5.3E+15 cm$^{-3}$, 5.4E+15 cm$^{-3}$, 5.5E+15 cm$^{-3}$, 5.6E+15 cm$^{-3}$, 5.7E+15 cm$^{-3}$, 5.8E+15 cm$^{-3}$, 5.9E+15 cm$^{-3}$, 6E+15 cm$^{-3}$, 6.1E+15 cm$^{-3}$, 6.2E+15 cm$^{-3}$, 6.3E+15 cm$^{-3}$, 6.4E+15 cm$^{-3}$, 6.5E+15 cm$^{-3}$, 6.6E+15 cm$^{-3}$, 6.7E+15 cm$^{-3}$, 6.8E+15 cm$^{-3}$, 6.9E+15 cm$^{-3}$, 7E+15 cm$^{-3}$, 7.1E+15 cm$^{-3}$, 7.2E+15 cm$^{-3}$, 7.3E+15 cm$^{-3}$, 7.4E+15 cm$^{-3}$, 7.5E+15 cm$^{-3}$, 7.6E+15 cm$^{-3}$, 7.7E+15 cm$^{-3}$, 7.8E+15 cm$^{-3}$, 7.9E+15 cm$^{-3}$, 8E+15 cm$^{-3}$, 8.1E+15 cm$^{-3}$, 8.2E+15 cm$^{-3}$, 8.3E+15 cm$^{-3}$, 8.4E+15 cm$^{-3}$, 8.5E+15 cm$^{-3}$, 8.6E+15 cm$^{-3}$, 8.7E+15 cm$^{-3}$, 8.8E+15 cm$^{-3}$, 8.9E+15 cm$^{-3}$, 9E+15 cm$^{-3}$, 9.1E+15 cm$^{-3}$, 9.2E+15 cm$^{-3}$, 9.3E+15 cm$^{-3}$, 9.4E+15 cm$^{-3}$, 9.5E+15 cm$^{-3}$, 9.6E+15 cm$^{-3}$, 9.7E+15 cm$^{-3}$, 9.8E+15 cm$^{-3}$, 9.9E+15 cm$^{-3}$, 1E+16 cm$^{-3}$, 1.1E+16 cm$^{-3}$, 1.2E+16 cm$^{-3}$, 1.3E+16 cm$^{-3}$, 1.4E+16 cm$^{-3}$, 1.5E+16 cm$^{-3}$, 1.6E+16 cm$^{-3}$, 1.7E+16 cm$^{-3}$, 1.8E+16 cm$^{-3}$, 1.9E+16 cm$^{-3}$, 2E+16 cm$^{-3}$, and any range between these values.

The minority carrier lifetime of the silicon wafer is greater than or equal to 200 μs, and may be, for example, 200 μs, 500 μs, 800 μs, 1000 μs, 1100 μs, 1200 μs, 1300 μs, 1400 μs, 1500 μs, 1600 μs, 1700 μs, 1800 μs, 1900 μs, 2000 μs, 2100 μs, 2200 μs, 2300 μs, 2400 μs, 2500 μs, 2600 μs, 2700 μs, 2800 μs, 2900 μs, 3000 μs, 3100 μs, 3200 μs, 3300 μs, 3400 μs, 3500 μs, 3600 μs, 3700 μs, 3800 μs, 3900 μs, 4000 μs, 4100 μs, 4200 μs, 4300 μs, 4400 μs, 4500 μs, 4600 μs, 4700 μs, 4800 μs, 4900 μs, 5000 μs, 5100 μs, 5200 μs, 5300 μs, 5400 μs, 5500 μs, 5600 μs, 5700 μs, 5800 μs, 5900 μs, 6000 μs, 6100 μs, 6200 μs, 6300 μs, 6400 μs, 6500 μs, 6600 μs, 6700 μs, 6800 μs, 6900 μs, 7000 μs, 7100 μs, 7200 μs, 7300 μs, 7400 μs, 7500 μs, 7600 μs, 7700 μs, 7800 μs, 7900 μs, 8000 μs, 8100 μs, 8200 μs, 8300 μs, 8400 μs, 8500 μs, 8600 μs, 8700 μs, 8800 μs, 8900 μs, 9000 μs, 9100 μs, 9200 μs, 9300 μs, 9400 μs, 9500 μs, 9600 μs, 10000 μs, 15000 μs, 20000 μs, 30000 μs, 40000 μs, 50000 μs, 60000 μs, 70000 μs, 80000 μs, 90000 μs, 100000 μs, 110000 μs, 120000 μs, 125000 μs, or 129000 μs, and any range between these values.

In a specific implementation, a concentration of an antimony element in the silicon wafer ranges from 4.30E+14 cm$^{-3}$ to 1.9E+16 cm$^{-3}$.

In a specific implementation, a concentration of an antimony element in the silicon wafer ranges from 4.45E+14 cm$^{-3}$ to 1.87E+16 cm$^{-3}$.

In a specific implementation, a concentration of an antimony element in the silicon wafer ranges from 4.30E+14 cm$^{-3}$ to 1.9E+16 cm$^{-3}$, and a measured minority carrier lifetime of the silicon wafer is greater than or equal to 300 μs.

In a specific implementation, a concentration of an antimony element in the silicon wafer ranges from 4.45E+14 cm$^{-3}$ to 1.87E+16 cm$^{-3}$, and a measured minority carrier lifetime of the silicon wafer is greater than or equal to 500 μs.

In a specific implementation, the resistivity of the silicon wafer ranges from 0.3 to 10 Ω·cm, and may be, for example, 0.3 Ω·cm, 0.4 Ω·cm, 0.5 Ω·cm, 0.6 Ω·cm, 0.7 Ω·cm, 0.8 Ω·cm, 0.9 Ω·cm, 1 Ω·cm, 1.1 Ω·cm, 1.2 Ω·cm, 1.3 Ω·cm, 1.4 Ω·cm, 1.5 Ω·cm, 1.6 Ω·cm, 1.7 Ω·cm, 1.8 Ω·cm, 1.9 Ω·cm, 2 Ω·cm, 2 Ω·cm, 2.5 Ω·cm, 3 Ω·cm, 3.5 Ω·cm, 4 Ω·cm, 4.5 Ω·cm, 5 Ω·cm, 5.5 Ω·cm, 6 Ω·cm, 6.5 Ω·cm, 7 Ω·cm, 7.5 Ω·cm, 8 Ω·cm, 8.5 Ω·cm, 9 Ω·cm, 9.5 Ω·cm, or 10 Ω·cm, and any range between these values.

In a specific implementation, a resistivity of the silicon wafer ranges from 0.4 to 8 Ω·cm.

In a specific implementation, a resistivity of the silicon wafer ranges from 0.5 to 6 Ω·cm.

There is a close relationship between the resistivity of the silicon wafer and the minority carrier lifetime. Specifically, a higher resistivity of the silicon wafer indicates a corresponding increase in the minority carrier lifetime. This is because a high resistivity indicates a relatively small quantity of lattice impurities. As a result, scattering of free electrons or holes is reduced, and the lifetime is prolonged. On the contrary, a silicon wafer with a low resistivity has a relatively large quantity of lattice impurities. As a result, electrons and holes are prone to scattering, and the lifetime is relatively short. However, a higher resistivity is not always better. If the concentration of resistivities is good, that is, the range of resistivities is narrow, the resistivities can be kept stable and uniform, which helps prolong the minority carrier lifetime, thereby improving cell efficiency.

In a specific implementation, a mechanical strength of the silicon wafer is greater than 70 MPa, and/or the dispersion degree of the mechanical strength is less than 0.9.

It should be noted that, if the side length of the silicon wafer is determined, the mechanical strength of the silicon wafer increases as the thickness of the silicon wafer increases.

The mechanical strength of the silicon wafer may be, for example, 70 MPa, 80 MPa, 90 MPa, 100 MPa, 110 MPa, 120 MPa, 140 MPa, 160 MPa, 180 MPa, 200 MPa, 210 MPa, 230 MPa, 250 MPa, 280 MPa, 300 MPa, 310 MPa, 320 MPa, 330 MPa, 340 MPa, 350 MPa, 360 MPa, 370 MPa, 380 MPa, 400 MPa, or 500 MPa, and any range between these values.

When a strength test is performed, a level detection platform is set, and two support beams are mounted on the level detection platform. A silicon wafer is placed on the two support beams, a span between the two support beams is 60 mm, and a thickness of the silicon wafer ranges from 40 μm to 170 μm. Then, push force is applied to the silicon wafer from top to bottom. Specific data of the applied pressure and a push distance are recorded by using a sensor, so as to measure a mechanical strength of the silicon wafer.

As competition of the photovoltaic industry is increasingly intensified, low costs become a core key, and thinning can effectively reduce costs of a silicon wafer and reduce optical attenuation of a cell, and the prepared cell has good flexibility. However, the prepared cell becomes worse in light absorption, and is extremely easy to warp, mainly because the mechanical strength is greatly reduced while thinning. In the silicon wafer of this application, by controlling the concentration of the antimony element, lattice glide is effectively hindered, to play a role in pinning a dislocation movement, thereby improving the mechanical strength of the silicon wafer.

During actual production and application, when the silicon wafer is thinned to a particular thickness, the mechanical performance of the silicon wafer is affected, and defective cells are easy to be generated. When the mechanical strength of the silicon wafer is greater than or equal to 70 MPa, the mechanical performance of the silicon wafer can be maintained at a relatively good level, excessive bending of cells when being stringed can be suppressed, so that fragments are not easy to be generated, a cell yield is improved, and product quality is ensured.

In a specific implementation, the dispersion degree of mechanical strengths of the silicon wafer is less than 0.9, and may be, for example, 0.89, 0.85, 0.8, 0.75, 0.7, 0.65, 0.6, 0.55, 0.5, 0.45, 0.4, 0.35, 0.3, 0.25, 0.2, 0.15, or 0.1, and any range between these values.

The specific size of the silicon wafer may be adjusted according to specific application needs. Because in this application, the uniformity of radial resistivities of the silicon wafer is good when the doping concentration of the silicon wafer falls within the foregoing range, a large-sized silicon wafer can be prepared.

In a specific implementation, a length of at least one side of the silicon wafer ranges from 156 mm to 300 mm, and may be, for example, $(158 \pm 2)$ mm, $(160 \pm 2)$ mm, $(165 \pm 2)$ mm, $(170 \pm 2)$ mm, $(175 \pm 2)$ mm, $(180 \pm 2)$ mm, $(185 \pm 2)$ mm, $(190 \pm 2)$ mm, $(195 \pm 2)$ mm, $(200 \pm 2)$ mm, $(205 \pm 2)$ mm, $(210 \pm 2)$ mm, $(215 \pm 2)$ mm, $(220 \pm 2)$ mm, $(225 \pm 2)$ mm, $(230 \pm 2)$ mm, $(235 \pm 2)$ mm, $(240 \pm 2)$ mm, $(245 \pm 2)$ mm, $(250 \pm 2)$ mm, $(255 \pm 2)$ mm, $(260 \pm 2)$ mm, $(265 \pm 2)$ mm, $(270 \pm 2)$ mm, or $(275 \pm 2)$ mm, and any range between these values.

In a specific implementation, the silicon wafer may be a rectangular wafer or a quasi-square wafer, or may be a half wafer obtained by cutting the rectangular wafer or the quasi-square wafer in half, and may be, for example, $(182 \pm 2)$ mm * $(91 \pm 2)$ mm, $(182 \pm 2)$ mm * $(83 \pm 2)$ mm, $(182 \pm 2)$ mm * $(105 \pm 2)$ mm, $(210 \pm 2)$ mm * $(91 \pm 2)$ mm, or $(210 \pm 2)$ mm * $(105 \pm 2)$ mm.

In a specific implementation, the thickness of the silicon wafer ranges from 40 to 170 μm, and may be, for example, 40 μm, 50 μm, 60 μm, 70 μm, 80 μm, 90 μm, 100 μm, 110 μm, 120 μm, 130 μm, 140 μm, 150 μm, 160 μm, or 170 μm.

A person skilled in the art can completely understand that the size of the silicon wafer may be further changed and adjusted based on the development of the field of photovoltaic cells.

In a specific implementation, the silicon wafer further includes a chamfer connected between two adjacent sides of the silicon wafer, and a projection length of an arc length of the chamfer ranges from 1 mm to 10 mm. For example, the projection length of the arc length of the chamfer is 2 mm, 3 mm, 4 mm, 5 mm, 6 mm, 7 mm, 8 mm, or 9 mm, and any range between these values.

The silicon wafer in this application further includes an impurity, and the impurity is selected from one or more of Fe, Cr, Ni, Cu, Mn, Zn, Mo, Ti, V, Co, and Sc.

Further, the silicon wafer may further include oxygen and/or carbon.

In a specific implementation of this application, the silicon wafer in this application is only doped with the antimony element as the fifth group doping element to replace the phosphorus element for doping. In this case, a person skilled in the art may understand that, depending on a source of a raw material of the silicon wafer or a manner of extra addition in the raw material for crystal pulling, the prepared silicon wafer may further contain another element, for example, any one or two or three of phosphorus, gallium, and germanium, but is actively doped with only the antimony element as the fifth group doping element to replace the phosphorus element for doping.

In a specific implementation, phosphorus is included in molten silicon for manufacturing a silicon wafer, to obtain a silicon wafer including both phosphorus and antimony. Due to a difference between evaporation rates of the antimony and phosphorus in a doping procedure, both of the two dopants affect the resistivity of the silicon ingot in an early stage of crystal pulling. As time goes by, antimony contributes less and less. After antimony volatilizes and is exhausted, that is, in a late stage of crystal pulling, only a single dopant phosphorus is in effect, so that the head and the tail of an ingot have relatively close resistivities, thereby improving the uniformity of axial resistivities, and correspondingly also improving the uniformity of resistivities in the silicon wafer.

In a specific manner, gallium is included in molten silicon for manufacturing a silicon wafer, to obtain a silicon wafer including both gallium and antimony. Specifically, in a method for preparing monocrystalline silicon, in one aspect, an appropriate amount of material gallium is added to the polycrystalline silicon material, and majority carrier holes are introduced, to obtain monocrystalline silicon with a preset resistivity. In the other aspect, an appropriate amount of material antimony is added to the polycrystalline silicon material, and free electrons are introduced, to compensate for holes in the silicon crystal, especially, at the tail of the monocrystalline silicon ingot, and reduce the concentration at the tail of the monocrystalline silicon ingot. In this way, longitudinal resistivity distribution of a prepared monocrystalline silicon ingot is more uniform, so that the length of the monocrystalline silicon ingot during production can be increased, and then resistivity uniformity in a silicon wafer prepared by cutting the silicon ingot is also improved.

In a specific manner, germanium is included in molten silicon for manufacturing a silicon wafer, to obtain a silicon wafer including both germanium and antimony. In a procedure of preparing monocrystalline silicon, if the monocrystalline silicon is doped with antimony, the monocrystalline silicon has a high volatilization rate and a large atomic radius, causing a lattice change. A trace amount of germanium is added as a dopant, and the quantity of electrons at the outermost layer of the germanium element and the quantity of electrons at the outermost layer of the silicon element are the same, and are both 4, which does not affect the electrical performance of the material silicon. However, native micro-defects, especially void defects, in the monocrystalline silicon can be suppressed through effects of germanium and point defects (self-interstitial silicon atoms and vacancies), so that quality and a yield of the monocrystalline silicon can be effectively improved, and native defects can be suppressed, to improve quality of the crystal.

Usually, in a silicon wafer, the concentration of the phosphorus element does not exceed 3E+16 atom/cm$^3$, the concentration of the gallium element does not exceed 7E+16 atom/cm$^3$, and the concentration of the germanium element does not exceed 1E+19 atom/cm$^3$. The foregoing concentration limits during simultaneous doping refer to respective concentration limits of the elements.

The inventor of this application studies, based on a first principle calculation, impact of antimony-doped silicon on an electronic structure of silicon, and a comparison analysis is performed between the impact and that of conventional P-doped silicon. A research result of calculation shows that by controlling the concentration of the antimony element, formation of vacancy defects is suppressed, and aggregation of the metal impurity and the oxygen impurity is reduced, thereby completing the technical solution of this application.

As described above, in this application, the inventor of this application finds that a concentration of an impurity in a silicon wafer needs to be controlled to fall within a particular range. In this way, the minority carrier lifetime of the silicon wafer can be further prolonged. In a specific implementation, the concentration of the antimony element in the silicon wafer in this application and a relative impurity level in the silicon wafer satisfy the following formula (1).

$$\frac{n_0 + a}{\tau_{SRH} \times b \times (n_0 + c)} \leq 5E-1 \quad (1)$$

where $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of cm$^{-3}$, cm/s, and cm$^{-3}$ respectively.

In a specific implementation, the concentration of the antimony element in the silicon wafer in this application and a relative impurity level in the silicon wafer satisfy the following formula (2):

$$\frac{n_0 + a}{\tau_{SRH} \times b \times (n_0 + c)} \leq 9E-2 \quad (2);$$

and where $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of cm$^{-3}$, cm/s, and cm$^{-3}$ respectively.

In a specific implementation, the concentration of the antimony element in the silicon wafer in this application and a relative impurity level in the silicon wafer satisfy the following formula (3):

$$5E-5 \leq \frac{n_0 + a}{\tau_{SRH} \times b \times (n_0 + c)} \leq 6E-2 \quad (3)$$

where $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of cm$^{-3}$, cm/s, and cm$^{-3}$ respectively.

where a is any value selected from 3.5E+18 to 5.5E+18, a is further preferably any value from 4E+18 to 5E+18, and a is further preferably 4.54E+18; b is any value selected from 0.8E+7 to 1.5E+7, b is further preferably any value from 0.9E+7 to 1.3E+7, and b is further preferably 1.1E+7; and c is any value selected from 1E+15 to 9E+15, c is further preferably any value from 1E+15 to 7E+15, and c is further preferably 3E+15.

For example, a may be 3.6E+18, 3.7E+18, 3.8E+18, 3.9E+18, 4.0E+18, 4.1E+18, 4.2E+18, 4.3E+18, 4.4E+18, 4.5E+18, 4.6E+18, 4.7E+18, 4.8E+18, 4.9E+18, 5.0E+18, 5.1E+18, 5.2E+18, 5.3E+18, or 5.4E+18, and further preferably, a is 4.54E+18. For example, b may be 0.9E+7, 1.0E+7, 1.1E+7, 1.2E+7, 1.3E+7, or 1.4E+7, and further preferably, b is 1.1E+7. For example, c may be 1E+15, 3E+15, 4E+15, 5E+15, or 6E+15, and further preferably, c is 3E+15.

In this application, for the silicon wafer satisfying the foregoing formula (1), formula (2), or formula (3), because a concentration of an impurity is controlled, a relatively long minority carrier lifetime of the silicon wafer can be achieved.

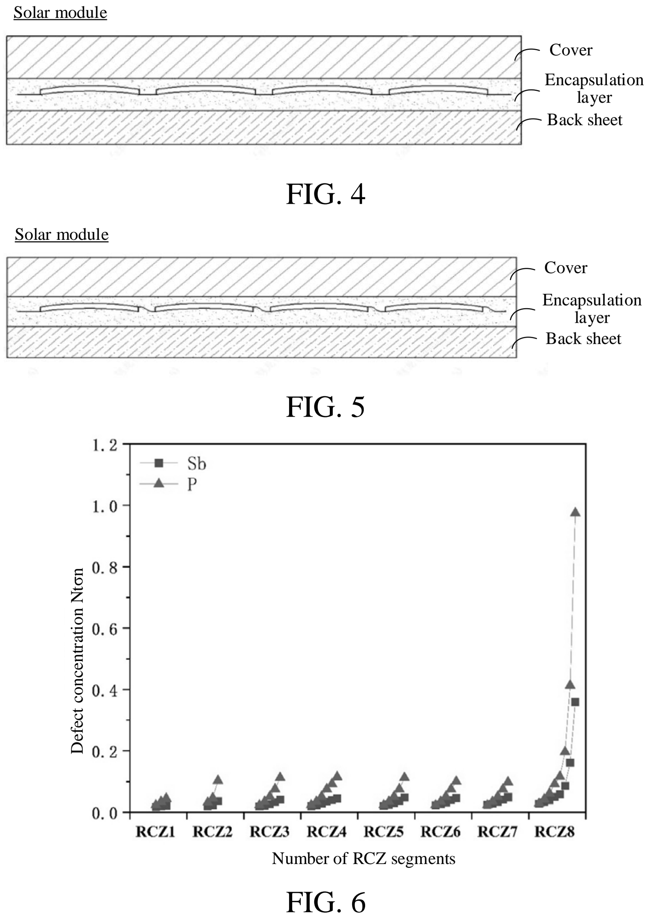

FIG. 6 is a schematic diagram of comparison between silicon ingot defect concentrations of an antimony-doped silicon ingot according to an embodiment of this application and an existing phosphorus-doped silicon ingot. The transversal axis represents the number of pulled segments of the silicon ingot, and the longitudinal axis represents the silicon ingot defect concentration. As shown in FIG. 6, in a procedure of continuously pulling an 8-segment silicon ingot, at a same doping concentration, a defect concentration of each segment of antimony-doped silicon ingot is lower than a defect concentration of a phosphorus-doped silicon ingot. Therefore, a silicon wafer made by using the antimony-doped silicon ingot has a lower defect concentration, and has a longer minority carrier lifetime, which helps improve the efficiency of the cell.

This application further provides a second silicon wafer. For the second silicon wafer, the concentration of the antimony element in the silicon wafer, and the resistivity, the mechanical strength, the size, the doping manner, and the like of the silicon wafer are as what are described above for the first silicon wafer, and details are not described below again. a concentration of an antimony element in the silicon wafer ranges from 4E+14 cm$^{-3}$ to 2E+16 cm$^{-3}$, and a minority carrier lifetime of the silicon wafer is greater than or equal to 300 $\mu$s.

The minority carrier lifetime of the silicon wafer is greater than or equal to 300 $\mu$s, and may be, for example, 300 $\mu$s, 500 $\mu$s, 800 $\mu$s, 1000 $\mu$s, 1100 $\mu$s, 1200 $\mu$s, 1300 $\mu$s, 1400 $\mu$s, 1500 $\mu$s, 1600 $\mu$s, 1700 $\mu$s, 1800 $\mu$s, 1900 $\mu$s, 2000 $\mu$s, 2100 $\mu$s, 2200 $\mu$s, 2300 $\mu$s, 2400 $\mu$s, 2500 $\mu$s, 2600 $\mu$s, 2700 $\mu$s, 2800 $\mu$s, 2900 $\mu$s, 3000 $\mu$s, 3100 $\mu$s, 3200 $\mu$s, 3300 $\mu$s, 3400 $\mu$s, 3500 $\mu$s, 3600 $\mu$s, 3700 $\mu$s, 3800 $\mu$s, 3900 $\mu$s, 4000 $\mu$s, 4100 $\mu$s, 4200 $\mu$s, 4300 $\mu$s, 4400 $\mu$s, 4500 $\mu$s, 4600 $\mu$s, 4700 $\mu$s, 4800 $\mu$s, 4900 $\mu$s, 5000 $\mu$s, 5100 $\mu$s, 5200 $\mu$s, 5300 $\mu$s, 5400 $\mu$s, 5500 $\mu$s, 5600 $\mu$s, 5700 $\mu$s, 5800 $\mu$s, 5900 $\mu$s, 6000 $\mu$s, 6100 $\mu$s, 6200 $\mu$s, 6300 $\mu$s, 6400 $\mu$s, 6500 $\mu$s, 6600 $\mu$s, 6700 $\mu$s, 6800 $\mu$s, 6900 $\mu$s, 7000 $\mu$s, 7100 $\mu$s, 7200 $\mu$s, 7300 $\mu$s, 7400 $\mu$s, 7500 $\mu$s, 7600 $\mu$s, 7700 $\mu$s, 7800 $\mu$s, 7900 $\mu$s, 8000 $\mu$s, 8100 $\mu$s, 8200 $\mu$s, 8300 $\mu$s, 8400 $\mu$s, 8500 $\mu$s, 8600 $\mu$s, 8700 $\mu$s, 8800 $\mu$s, 8900 $\mu$s, 9000 $\mu$s, 9100 $\mu$s, 9200 $\mu$s, 9300 $\mu$s, 9400 $\mu$s, 9500 $\mu$s, 9600 $\mu$s, 10000 $\mu$s, 15000 $\mu$s, 20000 $\mu$s, 30000 $\mu$s, 40000 $\mu$s, 50000 $\mu$s, 60000 $\mu$s, 70000 $\mu$s, 80000 $\mu$s, 90000 $\mu$s, 100000 $\mu$s, 110000 $\mu$s, 120000 $\mu$s, 125000 $\mu$s, 129000 $\mu$s, 130000 $\mu$s, 131000 $\mu$s, 132000 $\mu$s, 133000 $\mu$s, 134000 $\mu$s, or 134900 $\mu$s, and any range between these values.

In a specific implementation, a concentration of an antimony element in the silicon wafer ranges from 4.30E+14 cm$^{-3}$ to 1.9E+16 cm$^{-3}$.

In a specific implementation, a concentration of an antimony element in the silicon wafer ranges from 4.45E+14 cm$^{-3}$ to 1.87E+16 cm$^{-3}$.

In a specific implementation, a minority carrier lifetime of the silicon wafer is greater than or equal to 400 $\mu$s.

In a specific implementation, a minority carrier lifetime of the silicon wafer is greater than or equal to 600 $\mu$s.

In a specific implementation, a concentration of an antimony element in the silicon wafer ranges from 4.30E+14 cm$^{-3}$ to 1.9E+16 cm$^{-3}$, and a minority carrier lifetime of the silicon wafer is greater than or equal to 400 $\mu$s.

In a specific implementation, a concentration of an antimony element in the silicon wafer ranges from 4.45E+14 cm$^{-3}$ to 1.87E+16 cm$^{-3}$, and a minority carrier lifetime of the silicon wafer is greater than or equal to 600 $\mu$s.

A specific size of the silicon wafer, for example, the size described in detail in the first silicon wafer involved in this application, such as, the length of at least one side of the silicon wafer, the shape, area, and thickness of the silicon wafer, and a chamfer connected between two adjacent sides of the silicon wafer, may be adjusted according to a specific application requirement.

The inventor of this application finds that a concentration of an impurity needs to be controlled to fall within a particular range. In this way, the minority carrier lifetime can be further prolonged. In a specific implementation, the concentration of the antimony element in the silicon wafer in this application and a relative impurity level in the silicon wafer satisfy the following formula (1').

$$\frac{n_0 + a}{\tau_{SRH} \times b \times (n_0 + c)} \leq 1E - 1 \quad (1')$$

where $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of cm$^{-3}$, cm/s, and cm$^{-3}$ respectively.

In a specific implementation, the concentration of the antimony element in the silicon wafer in this application and a relative impurity level in the silicon wafer satisfy the following formula (2'):

$$\frac{n_0 + a}{\tau_{SRH} \times b \times (n_0 + c)} \leq 8E - 2 \quad (2');$$

and where $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of $cm^{-3}$, cm/s, and $cm^{-3}$ respectively.

In a specific implementation, the concentration of the antimony element in the silicon wafer in this application and a relative impurity level in the silicon wafer satisfy the following formula (3'):

$$4\text{E} - 5 \leq \frac{n_0 + a}{\tau_{SRH} \times b \times (n_0 + c)} \leq 5\text{E} - 2 \quad (3')$$

where $n_0$ is the concentration of the antimony element in the silicon wafer in a unit of $cm^{-3}$, $\tau_{SRH}$ is the minority carrier lifetime of the silicon wafer in a unit of second, and a, b, and c are fitting parameters and have units of $cm^{-3}$, cm/s, and $cm^{-3}$ respectively.

where a is any value selected from 3.5E+18 to 5.5E+18, a is further preferably any value from 4E+18 to 5E+18, and a is further preferably 4.54E+18; b is any value selected from 0.8E+7 to 1.5E+7, b is further preferably any value from 0.9E+7 to 1.3E+7, and b is further preferably 1.1E+7; and c is any value selected from 1E+15 to 9E+15, c is further preferably any value from 1E+15 to 7E+15, and c is further preferably 3E+15.

For example, a may be 3.6E+18, 3.7E+18, 3.8E+18, 3.9E+18, 4.0E+18, 4.1E+18, 4.2E+18, 4.3E+18, 4.4E+18, 4.5E+18, 4.6E+18, 4.7E+18, 4.8E+18, 4.9E+18, 5.0E+18, 5.1E+18, 5.2E+18, 5.3E+18, or 5.4E+18, and further preferably, a is 4.54E+18. For example, b may be 0.9E+7, 1.0E+7, 1.1E+7, 1.2E+7, 1.3E+7, or 1.4E+7, and further preferably, b is 1.1E+7. For example, c may be 2E+15, 3E+15, 4E+15, 5E+15, or 6E+15, and further preferably, c is 3E+15.

In a specific implementation, the second silicon wafer is obtained after gettering treatment is performed on the first silicon wafer. The antimony-doped monocrystalline silicon wafer is used. Through the gettering process, the minority carrier lifetime of the silicon wafer is prolonged by a fixed value. Compared with a conventional phosphorus-doped single crystal, the minority carrier lifetime of the antimony-doped silicon wafer on which gettering is performed is more significantly prolonged. In addition, after gettering, a cell prepared by using the antimony-doped monocrystalline silicon wafer has a significant short-circuit current improvement and an open-circuit voltage improvement.

In this application, for the silicon wafer satisfying the foregoing formula (1'), formula (2'), or formula (3'), because a concentration of an impurity is controlled, a relatively long minority carrier lifetime of the silicon wafer can be achieved.

In this application, the gettering treatment method may be among various methods known in the art, and may be, for example, tube-type gettering or chain-type gettering.

This application further provides a third silicon wafer, and the concentration of the antimony element in the silicon wafer and a relative impurity level in the silicon wafer satisfy the following formula (4):

$$\frac{n_0 + a}{\tau_{SRH} \times b \times (n_0 + c)} \quad (4)$$

where $n_0$ is the concentration of the antimony element in the silicon wafer in a unit of $cm^{-3}$, $\tau_{SRH}$ is the minority carrier lifetime of the silicon wafer in a unit of second, and a, b, and c are fitting parameters and have units of $cm^{-3}$, cm/s, and $cm^{-3}$ respectively;

where a is any value selected from 3.5E+18 to 5.5E+18, a is further preferably any value from 4E+18 to 5E+18, and a is further preferably 4.54E+18; b is any value selected from 0.8E+7 to 1.5E+7, b is further preferably any value from 0.9E+7 to 1.3E+7, and b is further preferably 1.1E+7; and c is any value selected from 1E+15 to 9E+15, c is further preferably any value from 1E+15 to 7E+15, and c is further preferably 3E+15.

For example, a may be 3.6E+18, 3.7E+18, 3.8E+18, 3.9E+18, 4.0E+18, 4.1E+18, 4.2E+18, 4.3E+18, 4.4E+18, 4.5E+18, 4.6E+18, 4.7E+18, 4.8E+18, 4.9E+18, 5.0E+18, 5.1E+18, 5.2E+18, 5.3E+18, or 5.4E+18, and further preferably, a is 4.54E+18. For example, b may be 0.9E+7, 1.0E+7, 1.1E+7, 1.2E+7, 1.3E+7, or 1.4E+7, and further preferably, b is 1.1E+7. For example, c may be 2E+15, 3E+15, 4E+15, 5E+15, or 6E+15, and further preferably, c is 3E+15.

A person skilled in the art may understand that, as long as a relative impurity level related to an impurity concentration in any silicon wafer, a concentration $n_0$ of an antimony element in the silicon wafer, and a minority carrier lifetime $\tau_{SRH}$ of the silicon wafer can be determined, and the silicon wafer satisfies the foregoing formula (4), the silicon wafer belongs to silicon wafers protected in this application.

In a specific implementation, a relative impurity level in the silicon wafer is below 5E-1 $cm^{-1}$. In a specific implementation, a relative impurity level in the silicon wafer is below 9E-2 $cm^{-1}$. In a specific implementation, a relative impurity level in the silicon wafer ranges from 5E-5 $cm^{-1}$ to 6E-2 $cm^{-1}$.

In a specific implementation, a relative impurity level in the silicon wafer is below 1E-1 $cm^{-1}$. In a specific implementation, a relative impurity level in the silicon wafer is below 8E-2 $cm^{-1}$. In a specific implementation, a relative impurity level in the silicon wafer ranges from 4E-5 $cm^{-1}$ to 5E-2 $cm^{-1}$.

In a specific implementation, a concentration of an antimony element in the silicon wafer ranges from 4E+14 $cm^{-3}$

to 2E+16 cm$^{-3}$.

In a specific implementation, a concentration of an antimony element in the silicon wafer ranges from 4.30E+14 cm$^{-3}$ to 1.9E+16 cm$^{-3}$.

In a specific implementation, a concentration of an antimony element in the silicon wafer ranges from 4.45E+14 cm$^{-3}$ to 1.87E+16 cm$^{-3}$.

In a specific implementation, a minority carrier lifetime of the silicon wafer is greater than or equal to 200 $\mu$s.

In a specific implementation, a minority carrier lifetime of the silicon wafer is greater than or equal to 300 $\mu$s.

In a specific implementation, a minority carrier lifetime of the silicon wafer is greater than or equal to 500 $\mu$s.

In a specific implementation, a minority carrier lifetime of the silicon wafer is greater than or equal to 300 $\mu$s.

In a specific implementation, a minority carrier lifetime of the silicon wafer is greater than or equal to 400 $\mu$s.

In a specific implementation, a minority carrier lifetime of the silicon wafer is greater than or equal to 600 $\mu$s.

This application further provides a cell. The cell is prepared by using any one of the foregoing silicon wafers.

The cell of this application includes a silicon substrate, where a doped region is provided inside a surface of at least one side of the silicon substrate, the silicon substrate contains an antimony element, the doped region is doped with a doping element, and the doping element is selected from Group IIIA elements or Group VA elements; a doping concentration of the antimony element in the silicon substrate ranges from 4E+14 cm$^{-3}$ to 2E+16 cm$^{-3}$, preferably ranges from 4.3E+14 cm$^{-3}$ to 1.9E+16 cm$^{-3}$, and further preferably ranges from 4.45E+14 cm$^{-3}$ to 1.87E+16 cm$^{-3}$; and a minority carrier lifetime of the silicon substrate is greater than or equal to 200 $\mu$s, preferably greater than or equal to 300 $\mu$s, and further preferably greater than or equal to 500 $\mu$s.

Descriptions for the silicon wafer in this application are completely applicable to the silicon substrate in the cell in this application.

In this application, because the concentration of the antimony element is properly controlled in the foregoing silicon wafer, to implement uniform doping, the resistivity of the silicon wafer or the bare silicon wafer is uniform. Using such a silicon wafer to prepare a cell can reduce the transverse transfer resistance of carriers, thereby finally improving the efficiency of the cell. In addition, by using the silicon wafer of this application, a minority carrier lifetime of the silicon wafer is relatively long to facilitate carrier migration, a short-circuit current of a prepared cell is improved, and cell efficiency is further improved.

In a specific manner, the silicon wafer in this application may be used for silicon substrates of various solar cells. The various solar cells include an aluminum back face field (Al-BSF) cell, a passivated emitter and rear contact (PERC) cell, a metal wrap-through (MWT) cell, a passivated emitter rear locally diffused (PERL) cell, a passivated emitter rear totally diffused (PERT) cell, an emitter wrap-through (EWT) cell, a tunneling oxide passivated contact (TOPCon) cell, an interdigitated back-contact (IBC) cell, a crystal silicon heterojunction (HJT/HIT) cell, and a full-back electrode heterojunction back-contact (HBC) cell.

Another aspect of this application relates to a solar cell. The solar cell includes a case in which the foregoing silicon wafer described in detail in this application is used for the solar cell. The detailed descriptions for the silicon wafer are substantially applicable. Specifically, the solar cell of this application includes a silicon substrate, where a doped region is provided inside a surface of at least one side of the silicon substrate, the silicon substrate contains an antimony element, the doped region is doped with a doping element, and the doping element is selected from Group IIIA elements or Group VA elements; a concentration of the antimony element in the silicon substrate ranges from 4E+14 cm$^{-3}$ to 2E+16 cm$^{-3}$, preferably ranges from 4.3E+14 cm$^{-3}$ to 1.9E+16 cm$^{-3}$, and further preferably ranges from 4.45E+14 cm$^{-3}$ to 1.87E+16 cm$^{-3}$.

A person skilled in the art may understand that the foregoing silicon substrate is a structure formed after a cell is prepared from a silicon wafer (including the first silicon wafer, the second silicon wafer, or the third silicon wafer) of this application. A person skilled in the art may understand that the foregoing solar cell is any solar cell to which the silicon wafer in this application can be applied, and may be, for example, a crystal silicon heterojunction (HJT/HIT) cell or a full-back electrode heterojunction back-contact (HBC) cell, or may be a TOPCon cell, a local TOPCon cell, a back-contact hybrid cell, a TBC cell, or any cell form well-known to a person skilled in the art.

In the foregoing cell form, there is at least one doped layer on a surface of at least one side of the foregoing silicon substrate. Specifically, depending on different cell forms, the dope layer may be selected based on a requirement, and may be, for example, an n-type amorphous or polycrystalline silicon carbide layer, or may be, for example, phosphorus-doped silicon carbide or nitrogen-doped silicon carbide; or may be n-type amorphous or polycrystalline silicon such as phosphorus-doped amorphous silicon or nitrogen-doped amorphous silicon; or may be n-type amorphous or polycrystalline diamond-like carbon such as nitrogen-doped diamond-like carbon. A person skilled in the art can make a selection completely as required as long as a requirement of this application is satisfied. A doped layer may be provided in at least some regions on a surface of at least one side of the silicon substrate, and another doped layer may be provided in other regions.

In the foregoing cell form, at least one passivation layer is provided between the foregoing doped layer and the doped region of the foregoing silicon substrate. Specifically, depending on different cell forms, the passivation layer may be selected based on a requirement. Usually, the thickness of the passivation layer should be less than 10 nm. Because the thickness is very small, there is no requirement on the electrical conductivity of the passivation layer. Because the thickness is small, there is no absorption limitation. Usually, the usable passivation layer includes silicon oxide, silicon nitride, intrinsic amorphous silicon, aluminum oxide, aluminum nitride, phosphorus nitride, titanium nitride, or the like. A person skilled in the art can make a selection completely as required as long as a requirement of this application is satisfied.

In a specific manner, the foregoing solar cell is a heterojunction cell, which may be, for example, a crystal silicon heterojunction (HJT/HIT) cell or a full-back electrode heterojunction back-contact (HBC) cell. In this application, when a silicon substrate formed by a silicon wafer is used as a heterojunction cell or a full-back electrode heterojunction back-contact cell, even after a heterojunction layer is stacked on the silicon substrate, the antimony concentration and the resistivity change rate that are elaborated for the foregoing silicon wafer are still satisfied. That is, after the heterojunction layer is stacked, the concentration of the antimony element in the silicon matrix ranges from $4E+14$ cm$^{-3}$ to $2E+16$ cm$^{-3}$. All of the foregoing descriptions for the antimony concentration and the resistivity change rate in the silicon wafer are applicable to this manner.

For a crystal silicon heterojunction (HJT/HIT) cell or a full-back electrode heterojunction back-contact (HBC) cell, generally, an intrinsic amorphous silicon layer and a doped amorphous silicon layer are further stacked on the silicon substrate of this application. The intrinsic amorphous silicon layer is used as a passivation layer. Due to characteristics of the Sb element, the antimony element in the silicon substrate does not enter the doped amorphous silicon layer through the passivation layer. The doped amorphous silicon layer substantially does not contain Sb. That is, the silicon substrate contains the antimony element, while the doped amorphous silicon layer or the intrinsic amorphous silicon layer contains a doping element but does not contain Sb.

More specifically, for a crystal silicon heterojunction (HJT/HIT) cell or a full-back electrode heterojunction back-contact (HBC) cell, the concentration of the antimony element in the foregoing silicon substrate ranges from $4.3E+14$ cm$^{-3}$ to $1.9E+16$ cm$^{-3}$. More specifically, the concentration of the antimony element in the foregoing silicon substrate ranges from $4.45E+14$ cm$^{-3}$ to $1.87E+16$ cm$^{-3}$.

In a specific manner, when the foregoing solar cell is a TOPCon cell, a local TOPCon cell, a back-contact hybrid cell, or a TBC cell, the solar cell of this application includes a silicon substrate, where a doped region is formed inside a surface of at least one side of the silicon substrate, the whole of the silicon substrate contains an antimony element, the doped region is doped with a doping element, and the doping element is selected from Group IIIA elements or Group VA elements; a concentration of the antimony element in the silicon substrate ranges from $4E+14$ cm$^{-3}$ to $2E+16$ cm$^{-3}$, preferably ranges from $4.3E+14$ cm$^{-3}$ to $1.9E+16$ cm$^{-3}$, and further preferably ranges from $4.45E+14$ cm$^{-3}$ to $1.87E+16$ cm$^{-3}$; and a minority carrier lifetime of the silicon substrate is greater than or equal to 200 $\mu$s, preferably greater than or equal to 300 $\mu$s, and further preferably greater than or equal to 500 $\mu$s.

More specifically, for a TOPCon cell, a local TOPCon cell, a back-contact hybrid cell, and a TBC cell, the concentration of the antimony element in the foregoing silicon substrate ranges from $4.3E+14$ cm$^{-3}$ to $1.9E+16$ cm$^{-3}$. More specifically, the concentration of the antimony element in the foregoing silicon substrate ranges from $4.45E+14$ cm$^{-3}$ to $1.87E+16$ cm$^{-3}$.

In a specific manner, for a TOPCon cell, a local TOPCon cell, a back-contact hybrid cell, and a TBC cell, as described above, the doped region contains a doping element, and the concentration of the antimony element in the doped region is substantially unchanged in a thickness direction of the silicon substrate. Therefore, in a procedure of pulling the antimony-doped silicon ingot, the doping atoms and the silicon atoms are in solid solution in the lattice. Therefore, the concentration of the antimony element in the doped region is substantially unchanged in a thickness direction of the silicon substrate, so that the lattice distortion of crystalline silicon caused by single-element doping to cause many defects in a heavily-doped region is overcome, and light absorption can be further improved, thereby improving the cell efficiency. In addition, by controlling the concentration of the antimony element to fall within the foregoing range, the carrier recombination effect can be reduced, the self-doping effect of the antimony element can be reduced, original and expected features of structural layers of the cell can be maintained, and good film layer quality can be achieved, which helps improve the conversion efficiency of the cell. A person skilled in the art may understand that for a TOPCon cell, a local TOPCon cell, a back-contact hybrid cell, and a TBC cell, in this application, a doped region is formed inside a raw material silicon wafer through direct doping or formed by another layer structure through indirect doping. Therefore, in this case, the doped region is formed in the silicon substrate by allowing a doping element to enter the silicon wafer. An interfacial passivation layer and a doped passivation layer may be further stacked on a surface of at least one side of the silicon substrate. In addition, a person skilled in the art may understand that, as long as the structure of the solar cell has the structure described in detail in this application, the structure with a different name also falls within the protection scope of this application.

In this application, the interfacial passivation layer is a layer that has a passivation function and allows a doping element to pass through, and may be, for example, a tunneling layer. The doped passivation layer refers to such a structure that a PN junction or a high-low junction is formed between the structure and the silicon matrix, for example, a doped amorphous silicon layer or a doped polycrystalline silicon layer.

In this application, being substantially unchanged means that concentrations of the antimony element in the thickness direction of the silicon substrate in this application are uniform. Although a specific value may change to some extent with a change of a detection site, a difference between the antimony concentrations in the thickness direction as a whole does not exceed 50%, 40%, 30%, 20%, 10%, 9%, 8%, 7%, 6%, 5%, 4%, 3%, 2%, or 1%. That is, a difference between a maximum value and a minimum value does not exceed 50%, 40%, 30%, or 20% of the minimum value, or 15% of the minimum value, or 10%, 9%, 8%, 7%, 6%, 5%, 4%, 3%, 2%, or 1% of the minimum value.

A person skilled in the art may understand that, according to different application requirements of the silicon wafer, for example, when the silicon wafer is used in various solar cells, the foregoing silicon wafer may be further doped with various doping elements, and one or more doped regions are formed. These doping elements may be Group IIIA elements, for example, boron, aluminum, gallium, indium, and thallium, or Group VA elements, for example, nitrogen, phosphorus, arsenic, antimony, and bismuth.

In this application, the concentration of the antimony element and the like described for the foregoing silicon wafer are also applicable to a silicon substrate that is mounted in a solar cell and that is used as a part of a light absorbing body. In this case, the foregoing parameters described for the concentration of the antimony element and the like in the silicon wafer are applicable to the whole silicon substrate, that is, are applicable to the bulk region doped with only the antimony element, are also applicable to the doped region, and are also applicable to the bulk region and the doped region as a whole. A person skilled in the art may understand that, when the foregoing detection is performed on only the bulk region, results obtained by measurement or calculation of the concentration of the antimony element, the resistivity, the resistivity change rate, and the average resistivity offset rate of the bulk region fall within the ranges described in detail in this application. When the foregoing detection is performed on only the doped region, a result obtained by measurement or calculation of the concentration of the antimony element of the doped region falls within the range described in detail in this application. The foregoing results can be similarly obtained when the boundary between the doped region and the bulk region is ignored and any site on the entire silicon substrate is detected.

In a specific manner, a manner in which the doped region is doped with the doping element may be direct doping, that is, the doped region is directly doped with the doping element without passing through another layer structure of the cell. The direct doping manner may be various methods known in the art. For example, the direct doping manner may be thermal diffusion, ion injection, or coating with a paste containing a dopant, where the dopant is added through a driving force (for example, thermal treatment or laser). The direct doping manner may be selected by a person skilled in the art according to a requirement. In addition, the direct doping manner also includes a case in which aluminum is diffused from an aluminum grid line into a silicon wafer through thermal treatment.

In a specific manner, other than the foregoing direct doping, a manner in which the doped region is doped with the doping element may alternatively be doping the silicon wafer or the silicon substrate with a doping element (that is, the doping element) through the foregoing layer structure stacked on the silicon wafer or the silicon substrate to form the foregoing doped region. A person skilled in the art may understand that, the layer structure may be correspondingly adjusted according to different application scenarios of the silicon wafer, for example, when the silicon wafer is used for different solar cells. For example, the layer structure itself may contain a dopant providing a doping element. In this case, the doping element is added through the layer structure. Alternatively, the layer structure itself may not contain a dopant, but a region adjacent to the layer structure has an atmosphere capable of providing a doping element, and the silicon wafer is doped with the doping element through, for example, thermal diffusion or ion injection to form a doped region. The foregoing atmosphere capable of providing the doping element may be a gas atmosphere (for example, a gas including a dopant), may be a liquid (for example, a paste including a dopant), or may be a solid (for example, a layer including a dopant, for example, a doped passivation layer, or particularly a doped polycrystalline silicon layer).

The layer structure may be one layer (for example, a passivation layer or a tunneling layer), or may be a plurality of layers. For example, a passivation layer and a doped layer are used as the layer structure together. The layer structure may be an auto-oxidation layer formed by auto-oxidation on a silicon matrix. Alternatively, intrinsic amorphous silicon may be used as the layer structure, that is, intrinsic amorphous silicon that plays a passivation role is disposed on a side of the silicon wafer.

Using a TOPCon cell structure as an example, a doped polycrystalline silicon layer (a doped passivation layer) or a tunneling layer (an interfacial passivation layer) may function as a layer structure, or a doped polycrystalline silicon layer and a tunneling layer may jointly function as a layer structure. A person skilled in the art may completely understand that, the foregoing listing is merely exemplary. The direct doping and the doping by using a layer structure are both optional, and the direct doping and the doping by using a layer structure may be performed on a part on a side of a silicon wafer. For example, a part is doped with a doping element through the direct doping, and a TOPCon structure is stacked on another region on a surface on the side to form a local TOPCon structure or form a back-contact hybrid cell having a TOPCon structure. Alternatively, even a TOPCon structure may be locally used, and another TOPCon structure may be used in another position, to separately implement doping, for example, to form a TBC cell.

A person skilled in the art may understand that, in the presence of a TOPCon structure, a tunneling layer and a doped polycrystalline silicon layer are further superposed on the silicon substrate, and a concentration of the antimony element in the silicon substrate ranges from 4E+14 cm$^{-3}$ to 2E+16 cm$^{-3}$, preferably ranges from 4.3E+14 cm$^{-3}$ to 1.9E+16 cm$^{-3}$, and further preferably ranges from 4.45E+14 cm$^{-3}$ to 1.87E+16 cm$^{-3}$.

In this application, by controlling the doping concentration of the antimony element in the silicon substrate, the uniformity and the concentration of the resistivity of the silicon wafer can be correspondingly good. In this way, at a machining stage of the cell, an additional process does not need to be used to introduce the antimony element into the silicon wafer. Compared with a conventional N-type cell in which an antimony element is introduced through a silver paste and ion injection at a machining stage of the cell, in this application, the antimony element is introduced at the machining stage of the cell without an additional procedure, thereby simplifying a manufacturing process of a solar cell and reducing machining costs of the cell.

In a specific manner, in a case of the direct doping, within a range of a thickness h from a surface on a side of the doped region away from the silicon substrate (that is, a doping depth of a directly doped region), on the surface and in a position at a same depth from the surface, a concentration of the doping element is greater than a concentration of the antimony element. In addition, in the doped region, a sum of the concentration of the antimony element and a concentration of the doping element is less than or equal to 1E+21 cm$^{-3}$. According to the cell of this application, because a range of a sum of a concentration in a doped region and a concentration of a doping element is controlled, carrier separation is facilitated, carrier recombination is reduced, and a short-circuit current and an open-circuit voltage are increased.

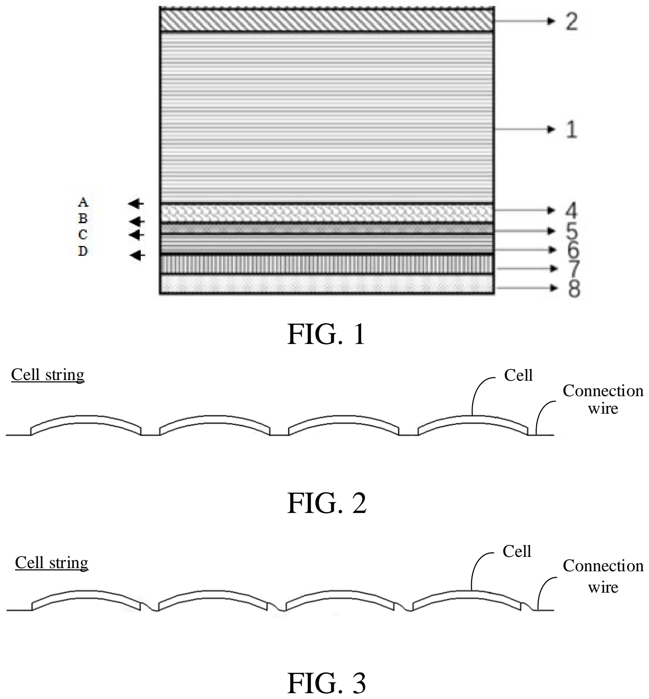

In a specific manner, the doping element is a Group IIIA element, and h is in a range of 30 to 650 nm. In a specific manner, the doping element is a Group IIIA element, and h is greater than or equal to 400 nm. In a specific manner, the doping element is a Group IIIA element, and h is in a range of 30 nm to 100 nm. In a specific implementation, the doping element is a Group VA element, and h is in a range of 100 to 200 nm. As described above, a maximum range in the position at the same depth from the surface should be the thickness h. For example, when the depth is 0, the concentration in the foregoing doped region is the concentration on the surface of the foregoing doped region. When the depth is 100 nm, for example, at a position 100 nm from the foregoing surface, the concentration of the doping element is greater than the concentration of the antimony element. In a specific manner, as shown in FIG. 1, a surface on a side of the doped region away from the silicon matrix is a front face of the doped region 2.

In a specific manner, the foregoing doping element is a boron element, and h is in a range of 30 to 650 nm or h is in a range of 30 nm to 100 nm. When only local doping is performed, only a position of the local doping needs to satisfy the foregoing relationship.

In this application, because the thickness of the doped region formed by direct doping in the silicon substrate of the foregoing solar cell is controlled, carrier separation is facilitated, carrier recombination is reduced, and a short-circuit current and an open-circuit voltage are increased.

In some specific manners, if the thickness of the doped region formed by direct doping, for example, the thickness of the doped region doped with a Group IIIA element, is further controlled to even be less than 100 nm or even to be less than 50 nm, Auger recombination of free carriers is further reduced, and the short-circuit current is further improved. In a specific manner, in a case of performing diffusion through the layer structure, within a range of a thickness m from a surface on a side of the doped region away from the silicon substrate (the depth of the doped region in a case in which the layer structure is used for diffusion), on the surface and in a position at a same depth from the surface, a concentration of the doping element is greater than a concentration of the antimony element. In a specific manner, as shown in FIG. 1, a surface on a side of the doped region away from the silicon substrate is a back face of the doped region 4.

In a specific manner, the doping element is a Group IIIA element, and m is in a range of 80 to 180 nm. In a specific implementation, the doping element is a Group VA element, and m is in a range of 30 to 100 nm. As described above, a maximum range in the position at the same depth from the surface should be less than or equal to m. For example, when the depth is 0, the concentration in the foregoing doped region is the concentration on the surface of the foregoing doped region. When the depth is 100 nm, for example, at a position 100 nm from the foregoing surface, the concentration of the doping element is greater than the concentration of the antimony element.

In a specific manner, the foregoing doping element is a phosphorus element, and m is in a range of 80 to 180 nm or m is in a range of 30 to 100 nm. When only local doping is performed, only a position of the local doping needs to satisfy the foregoing relationship.

In this application, because the thickness of the doped region formed by the layer structure through doping is controlled, the foregoing light absorbing body not only retains a passivation effect of the interfacial passivation layer, but also implements effective doping of the doped polycrystalline silicon layer, thereby increasing a short-circuit current and an open-circuit voltage, and increasing efficiency of the cell.

In a specific manner, the solar cell in this application is, for example, a tunneling oxide passivated contact cell (TOPCon cell) cell, a local TOPCon cell, a back-contact hybrid cell, or a TBC cell.

In a specific implementation, a typical structure of the TOPCon cell is shown in FIG. 1, and sequentially includes a silicon substrate 1 (a second doped region 2 and a first doped region 4 are formed inside surfaces on two sides of the silicon substrate), a tunneling layer 5, a doped polycrystalline silicon layer 6, a passivation layer or high-transfer film layer 7, and an electrode 8 in a direction from a front face to a back face. A person skilled in the art may completely understand that, although the structure of the TOPCon cell is described with reference to FIG. 1, the structure of the TOPCon cell is not limited to the structure in FIG. 1, provided that the silicon substrate of the cell has a tunneling layer and a doped polycrystalline silicon layer. The TOPCon structure may be formed on the entire silicon substrate or may be formed on at least some regions of the silicon substrate.

In a specific manner, the second doped region 2 is directly doped with a boron element, and the first doped region 4 is doped with a phosphorus element in the silicon substrate through the tunneling layer 5 and the doped polycrystalline silicon layer 6.

The local TOPCon cell means that a TOPCon structure (that is, a first doped region, a tunneling layer, and a doped polycrystalline silicon layer) is formed on at least some regions of one surface of the cell, a first local region has the first doped region, the tunneling layer, and the doped polycrystalline silicon layer, and regions other than the first local region are other doped regions. The other doped regions and the first doped region are on a same surface, elements with which the other doped regions and the first doped region are doped are the same in conduction type, but the other side is doped with an element having an opposite conduction type, to form a second doped region.

In actual application, lattice distortion is caused due to single-element doping. Generally, lattice distortion of crystalline silicon is caused due to single-element doping to cause many defects in a heavily-doped region. In this application, two doped regions are disposed, the doped passivation layer is doped with the first doping element, and the second doped region on the silicon substrate is further doped with the second doping element, so that the solar cell of this application can effectively prevent occurrence of lattice distortion.

The TBC cell means that a TOPCon structure is formed on the back face of the cell, there are two regions on the back face of the cell, and the two regions respectively have TOPCon structures with doping elements in opposite conduction types.

The back-contact hybrid cell refers to a cell in which one region has a PERC or PERL structure and the other region has a TOPCon structure. For example, one region of the back face has a TOPCon structure, the other region has a PERL or PERC structure, and the two regions are doped with elements having opposite conduction types. In some specific manners, when an aluminum grid line is used for doping, a metal layer is formed on the silicon substrate, and an alloy layer and a BSF layer are formed in the silicon substrate. The BSF layer is a doped region. In this case, a surface on a side of the doped region away from the silicon matrix refers to a surface on a side of the BSF layer away from the silicon substrate.

In a specific manner, the solar cell in this application may be any one of the foregoing four types, that is, a TOPCon cell, a local TOPCon cell, a back-contact hybrid cell, and a TBC cell. In these four types of cells, the foregoing doping element is added into the silicon substrate through the layer structure on the silicon substrate to form the foregoing doped region, the foregoing doped region includes a first doped region and a second doped region, and the layer structure on the silicon substrate includes a tunneling layer and a doped polycrystalline silicon layer that are sequentially stacked on a surface on a side of the first doped region away from the silicon substrate. The doped polycrystalline silicon layer is doped with a first doping element, the second doped region on the silicon substrate is further doped with a second doping element, and a conduction type of the first doped region is opposite to that of the second doped region.

In this application, the "first doping element" and the "second doping element" are different doping elements. For example, when the first doping element is a Group VA element, the second doping element is a Group IIIA element; and when the first doping element is a Group IIIA element, the second doping element is a Group VA element.

In a specific manner, the first doping element is a phosphorus element, and the second doping element is a boron element.

When the solar cell in this application is a TOPCon cell, a local TOPCon cell, or a back-contact hybrid cell, the second doped region is the foregoing second doped region directly doped with the second doping element. The first doping element is a Group VA element (for example, phosphorus), and the second doping element is a Group IIIA element (for example, boron).

In a specific manner, in the doped polycrystalline silicon layer, a concentration of the first doping element at a depth x (namely, a first preset depth) away from a surface on a side of the doped polycrystalline silicon layer away from the silicon substrate is greater than a concentration of the second doping element at the depth x (namely, the first preset depth) away from a surface of the second doped region, a thickness range of the doped polycrystalline silicon layer is from 100 to 400 nm, and x is less than or equal to a thickness of the doped polycrystalline silicon layer. In this manner, because the concentration of the first doping element is greater than the concentration of the second doping element, Auger recombination of free carriers can be further reduced, and the short-circuit current can be further improved. In a specific manner, in a direction from the doped polycrystalline silicon layer to the tunneling layer, in the tunneling layer, a concentration of the first doping element at a depth y (namely, a second preset depth) away from a surface of a side of the doped polycrystalline silicon layer away from the silicon substrate is greater than a concentration of the second doping element at the depth y (namely, the second preset depth) away from a surface of the second doped region, a thickness range of the tunneling layer is from 0.5 to 5 nm, and y is less than or equal to a sum of thicknesses of the doped polycrystalline silicon layer and the tunneling layer.

If a heavily-doped region exists on a front surface of the cell, severe Auger recombination may be generated, causing severe light absorption, and affecting cell efficiency. In this manner, because the concentration of the first doping element is greater than the concentration of the second doping element, Auger recombination of free carriers can be further reduced, and the short-circuit current can be further improved. In another aspect, Auger recombination of free carriers can be reduced without reducing a passivation effect of a tunneling layer, thereby further improving the short-circuit current, the open-circuit voltage, and the cell efficiency. In a specific manner, in a direction from the doped polycrystalline silicon layer to a surface of the first doped region, in the silicon substrate, a concentration of the first doping element at a depth z (namely, a third preset depth) away from a surface of a side of the doped polycrystalline silicon layer away from the silicon substrate is greater than a concentration of the second doping element at the depth z (namely, the third preset depth) away from a surface of the second doped region, a thickness range of the first doped region is from 30 to 100 nm, and z is less than or equal to a sum of thicknesses of the doped polycrystalline silicon layer, the tunneling layer, and the first doped region. In this manner, because the concentration of the first doping element is greater than the concentration of the second doping element, Auger recombination of free carriers can be further reduced, and the short-circuit current can be further improved. In another aspect, Auger recombination of free carriers can be reduced without reducing a passivation effect of a tunneling layer, thereby further improving the short-circuit current, the open-circuit voltage, and the cell efficiency.

As described above, a distribution situation of element concentration of a doped region of a silicon substrate of a cell is described in detail. Positions of x, y, and z are described with the help of a TOPCon cell shown in FIG. 1. As shown in FIG. 1, a surface on a side of the doped polycrystalline silicon layer away from the silicon substrate is a surface shown by D, where a maximum value of x is a distance between D and C; a maximum value of y is a distance between D and B; and a maximum value of z is a distance between D and A.

When the solar cell in this application is a TBC cell, the first doping element is a Group VA element (for example, phosphorus), and the second doping element is a Group IIIA element (for example, boron). The layer structure on the silicon substrate further includes a second layer structure, and the second layer structure includes a tunneling layer and a doped polycrystalline silicon layer that are sequentially stacked on a surface on a side of the second doped region away from the silicon substrate. The second doped region is a doped region formed by allowing the second doping element to pass through the second layer structure on the foregoing silicon substrate.

In a specific manner, in the doped polycrystalline silicon layer, a concentration of the first doping element at a depth x (namely, a first preset depth) away from a surface of a side of the doped polycrystalline silicon layer of the first doped region away from the silicon substrate is greater than a concentration of the second doping element at the depth x (namely, the first preset depth) away from a surface of a side of the doped polycrystalline silicon layer of the second doped region away from the silicon substrate, a thickness range of the doped polycrystalline silicon layer on the first doped region is from 100 to 400 nm, a thickness range of the doped polycrystalline silicon layer on the second doped region is from 100 to 400 nm, and x is less than or equal to a thickness of the doped polycrystalline silicon layer on the first doped region. In a specific manner, the tunneling layer of the first doped region is doped with a first doping element, and the tunneling layer of the second doped region is doped with a second doping element; and in a direction from the doped polycrystalline silicon layer to the tunneling layer, in the tunneling layer, a concentration of the first doping element at a depth y (namely, a second preset depth) away from a surface of a side of the doped polycrystalline silicon layer of the first doped region away from the silicon substrate is greater than a concentration of the second doping element at the depth y (namely, the second preset depth) away from a surface of a side of the doped polycrystalline silicon layer of the second doped region away from the silicon substrate, a thickness range of the tunneling layer on the first doped region is from 0.5 to 5 nm, a thickness range of the tunneling layer on the second doped region is from 0.5 to 5 nm, and x is less than or equal to a sum of thicknesses of the doped polycrystalline silicon layer and the tunneling layer on the first doped region. In a specific implementation, in a direction from the doped polycrystalline silicon layer to a surface of the first doped region, in the silicon substrate, a concentration of the first doping element at a depth z (namely, a third preset depth) away from a surface of a side of the doped polycrystalline silicon layer of the first doped region away from the silicon substrate is greater than a concentration of the second doping element at the depth z (namely, the third preset depth) away from a surface of a side of the doped polycrystalline silicon layer of the second doped region away from the silicon substrate, a thickness range of the first doped region is from 30 to 100 nm, and z is less than or equal to a sum of thicknesses of the doped polycrystalline silicon layer and the tunneling layer on the first doped region, and the first doped region.

In this application, regardless of a TOPCon cell, a local TOPCon cell, a back-contact hybrid cell, or a TBC cell, because the silicon substrate is uniformly doped with both an antimony element and a doping element, an resistivity of the silicon substrate and the light absorbing body is very uniform, an resistivity change rate is small, and an average resistivity offset rate is small, a transverse transfer resistance of a carrier can be effectively reduced, and the efficiency of the cell can be effectively improved.

In a specific manner, the cell of this application includes an electrode formed on a light absorbing body, the electrode includes a metallic crystal part in contact with the light absorbing body, and the metallic crystal part includes the antimony element, where the light absorbing body includes the silicon substrate and a region for separating carriers generated by the silicon substrate.

In this application, the foregoing metallic crystal refers to an alloy formed by metal in an electrode and silicon in a procedure of forming the electrode.

In a specific manner, the metallic crystal part further includes a doping element, and a concentration of the doping element is greater than a concentration of the antimony element.

Because the metallic crystal part of the electrode of the cell of this application contains the antimony element, contact resistance of the solar cell can be reduced and the contact resistance of the module can be further reduced.

In a specific manner, the mechanical strength of the solar cell of this application is greater than or equal to 50 MPa.

This application further includes a cell string structure, including a plurality of solar cells of this application that are connected to each other by using a conductive interconnection member.

In a specific manner, the conductive interconnection member may be, for example, a conductive connection wire (sometimes also referred to as a metal solder strip), or may be a conductive trace in a conductive back sheet.

Specifically, before forming a photovoltaic module, the cells need to undergo a stringing (or string soldering) step. Specifically, referring to FIG. 2, a plurality of cells is connected by using a plurality of conductive connection wires, and may be, for example, connected in series. The connection wire may be a metal line structure, a cross section of the connection wire may be a circular cross section, a triangular cross section, or the like, and the connection wire may be formed by a base body and a bonding layer wrapped around the base body.

In this application, whether the connection is performed by using the conductive connection wire (a metal solder strip) or the conductive trace formed on the conductive back sheet, it is only required that the cell is in contact with the conductive interconnection member through the electrode, and the contact part includes the antimony element. Such a structure can further reduce the contact resistance of the cell string.

In the stringing step, an electrical connection is performed through soldering. In the soldering procedure, a heating operation needs to be performed, mainly aiming to fuse the bonding layer of the connection wire to form an electrical connection with the cell. However, in the heating step, the top-bottom stress of the cell may be uneven, and the top-bottom uneven pressure may cause bending. However, a larger bending in the stringing procedure indicates a larger risk of hidden cracking and fragmentation of the cell during laminating. The mechanical strength of the cell involved in this application is greater than 50 MPa. Its relatively large mechanical strength can suppress excessive bending of cells when being stringed, which can improve the module yield to some extent. Generally, a curvature of a back-contact cell is greater than a curvature of a bifacial cell, because a stress difference between upper and lower surfaces of the back-contact cell is larger. The back-contact cell means that an electrical interconnection structure is provided on only one surface of the cell, and the bifacial cell means that an electrical interconnection structure is provided on each of two opposite surfaces of the cell.

Specifically, referring to FIG. 2, the curvature of the back-contact cell is less than or equal to 2 mm after being heated and stringed at 165 to 200 degrees Celsius, and is less than or equal to 1.5 mm after being heated and stringed at a low temperature of 100 to 160 degrees Celsius. Referring to FIG. 3, the curvature of the bifacial cell is less than or equal to 1.2 mm after being heated and stringed at 165 to 200 degrees Celsius, and is less than or equal to 1 mm after being heated and stringed at a low temperature of 100 to 160 degrees Celsius. It may be learned that, the specially doped cell of the present disclosure has a relatively small curvature, which can well control problems of hidden cracking and fragmentation during laminating. It should be noted that the curvature involved in this application refers to a height or a depth of a protrusion or a recess that is generated on a surface of a cell when the cell is bent, and may be obtained by measuring a curvature radius of an edge of the cell.

This application further relates to a solar module, including a plurality of cells of this application, an encapsulation layer, a cover, and a back sheet, where the plurality of cells are sealed in the encapsulation layer, and the encapsulation layer is located between the cover and the back sheet.

The cell string in this application is formed into a cell module through processes such as layout, superposing, and laminating. For the formed cell module, refer to FIG. 4 and FIG. 5. When a laminating process is performed, pressure application and heating are required, so that the encapsulation layer is used to fuse and seal the cell string, and is attached to a cover and a back sheet. The encapsulation layer is located between the cover and the back sheet. In the laminating process, due to the foregoing pressure application and heating operations, some stress of the cell is released and suppressed. For the back-contact cell, referring to FIG. 4, the curvature of the cell in the laminated cell module is less than or equal to 1.2 mm. For the bifacial cell, referring to FIG. 5, the curvature of the cell in the laminated cell module is less than or equal to 0.8 mm. It is verified that the problems of hidden cracking and fragmentation of the laminated cell are significantly controlled. It can be seen from FIG. 3 and FIG. 5 that, a bending direction of the cell is toward the cover, that is, the cell projects toward the cover to form a curved shape.

Specifically, the encapsulation layer may be at least one of EVA, POE, silica gel, and PVB. The cover is close to a light receiving surface of the cell, and is transparent and organic or organic. Preferably, the cover may be low-iron patterned glass. The thickness of the cover is preferably 2.0 or 3.2 mm. The back sheet may be a transparent or non-transparent material. For a double-glazed module, the back sheet is a transparent material, and is preferably glass. For a single-glazed module, the back sheet may be non-transparent, and may be, for example, a TPC sheet. Further, the cell module further includes a frame, the frame has a slot-shaped mounting part for accommodating a laminate, and edges of the cover and the back sheet are embedded in the mounting part of the frame.

This application further relates to a process of performing phosphorus diffusion on a silicon wafer, which includes: performing a heating procedure, a pre-oxidation procedure, a deposition procedure, a post-oxidation procedure, a temperature reduction procedure, and a cooling procedure under controlled nitrogen and oxygen flow rates. Generally, a relatively high flow rate of nitrogen may be controlled to perform related treatment, and the deposition may be performed once or twice based on requirements.

Specifically, this application relates to the following phosphorus gettering diffusion process, including: Start stage: a time period is 10 s, a temperature is set to 770 to 800 °C, a large nitrogen flow rate is 9 L/min, and small nitrogen and oxygen flow rates are both 0 L/min. Boat loading stage: A time period is 510 s, a temperature is set to 770 to 800 °C, a large nitrogen flow rate is 9 L/min, small nitrogen and oxygen flow rates are 0 L/min, and a boat loading speed is 400 mm/min. Temperature rise stage: A time period is 600 s, a temperature is set to 820 to 850 °C, a large nitrogen flow rate is 18 L/min, and small nitrogen and oxygen flow rates are both 0 L/min. Pre-Oxidation stage: A time period is 600 s, a temperature is set to 820 to 850 °C, a large nitrogen flow rate is 16 L/min, and a small nitrogen flow rate is 0 L/min, and an oxygen flow rate is 2 L/min. First time of deposition: A time period is 600 s, a temperature is set to 820 to 850 °C, a large nitrogen flow rate is 14 L/min, and a small nitrogen flow rate is 2 L/min, and an oxygen flow rate is 2 L/min. First time of push: A time period is 600 s, a temperature is set to 820 to 850 °C, a large nitrogen flow rate is 18 L/min, and a small nitrogen flow rate is 0 L/min, and an oxygen flow rate is 0 L/min. Second time of deposition: A time period is 900 s, a temperature is set to 850 to 880 °C, a large nitrogen flow rate is 14.4 L/min, and a small nitrogen flow rate is 1.8 L/min, and an oxygen flow rate is 1.8 L/min. Second time of push: A time period is 1200 s, a temperature is set to 850 to 880 °C, a large nitrogen flow rate is 18 L/min, and a small nitrogen flow rate is 0 L/min, and an oxygen flow rate is 0 L/min. Post-oxidation and temperature reduction stage: A time period is 1800 s, a temperature is set to 780 to 800 °C, a large nitrogen flow rate is 14 L/min, and a small nitrogen flow rate is 0 L/min, and an oxygen flow rate is 4 L/min. Boat unloading stage: A time period is 510 s, a temperature is set to 780 °C, a large nitrogen flow rate is 9 L/min, small nitrogen and oxygen flow rates are 0 L/min, and a boat unloading speed is 250 mm/min. End stage: A time period is 10 s, a temperature is set to 780 °C, a large nitrogen flow rate is 9 L/min, and small nitrogen and oxygen flow rates are both 0 L/min. Cooling stage: The foregoing silicon wafer is allowed to cool to room temperature, to obtain a required gettered silicon wafer.

In this application, the silicon wafer involved in this application is not further limited, and may be a silicon wafer (which may also be referred to as a bare silicon wafer) obtained after a silicon ingot is pulled and then machined and sliced, may be a silicon wafer obtained through doping, or may be a partial silicon substrate that is stripped and recovered from the cell module, provided that the silicon substrate can have a particular shape and can present a sheet shape, that is, have a size on one surface greater than a size of a surface perpendicular to the one surface, and have a flat shape or a sheet shape.

Examples

In this application, materials and test methods used in the tests are generally and/or specifically described. In the following embodiments, unless otherwise specified, % represents weight%, that is, weight percentage. Any used reagent or instrument without a manufacturer mark is a common commercially available reagent product.

Example 1

A quartz crucible was loaded with a polycrystalline silicon block. For example, a solid silicon raw material was first placed in the quartz crucible, and then the quartz crucible filled with the silicon material was placed in a single crystal furnace.

The single crystal furnace was evacuated, a heater of the single crystal furnace was turned on, and the solid silicon in the quartz crucible was gradually melted into a fused state.

Because the solid silicon material in the quartz crucible after being heated and melted, the actual volume occupied decreased and the melted silicon material does not reach a maximum loading amount of the quartz crucible, the quartz crucible needs to be filled with the silicon material for the second time by using an external loader such as a quartz tube loading barrel. In this embodiment, loading needs to be performed by using the quartz tube, and in a loading procedure, the heater synchronously performs melting treatment on the silicon material in the quartz crucible.

An antimony-containing dopant and the silicon material were added to the quartz crucible together. After the silicon material in the quartz crucible is all melted, switching to a temperature regulation step was performed, a seed crystal was inserted into a silicon liquid, and a critical crystallization temperature of a liquid surface temperature was reached by controlling a power parameter and the like.

The seed crystal was pulled upward after the seed crystal and the liquid surface reached the crystallization temperature point.

After the length of the seed crystal reached a required length of 15 to 20 mm and the diameter of the seed crystal was within 5 to 10 mm, an actual single crystal diameter was set to be within a range of 252 ± 1 mm round ingot diameter. After shoulder growth completion, the process transitions into the constant-diameter growth phase of the silicon crystal via shoulder rotation.

In the constant-diameter growth phase, a pull speed, a power, and the like were adjusted, until a constant-diameter growth phase length was 3800 mm.

The diameter of the silicon ingot was reduced to perform tailing, thereby completing pulling of the silicon ingot.

The silicon ingot was cut by using a cutting-off machine to a suitable length, and the silicon ingot was machined into a square ingot after being flowed to a square cutter. The square ingot was ground and polished by using a polisher, and then was flowed to a slicer, and the silicon square ingot was sliced and machined into a silicon wafer by using a diamond wire.

Further, a phosphorus diffusion gettering process is performed on the foregoing obtained silicon wafer, and specific steps are as follows:

(1) Start: A time period is 10 s, a temperature is set to 770 to 800 °C, a large nitrogen flow rate is 9 L/min, and small nitrogen and oxygen flow rates are both 0 L/min.

(2) Boat loading: A time period is 510 s, a temperature is set to 770 to 800 °C, a large nitrogen flow rate is 9 L/min, small nitrogen and oxygen flow rates are 0 L/min, and a boat loading speed is 400 mm/min.

(3) Temperature rise: A time period is 600 s, a temperature is set to 820 to 850 °C, a large nitrogen flow rate is 18 L/min, and small nitrogen and oxygen flow rates are both 0 L/min.

(4) Pre-oxidation: A time period is 600 s, a temperature is set to 820 to 850 °C, a large nitrogen flow rate is 16 L/min, and a small nitrogen flow rate is 0 L/min, and an oxygen flow rate is 2 L/min.

(5) First time of deposition: A time period is 600 s, a temperature is set to 820 to 850 °C, a large nitrogen flow rate is 14 L/min, and a small nitrogen flow rate is 2 L/min, and an oxygen flow rate is 2 L/min.

(6) First time of push: A time period is 600 s, a temperature is set to 820 to 850 °C, a large nitrogen flow rate is 18 L/min, and a small nitrogen flow rate is 0 L/min, and an oxygen flow rate is 0 L/min.

(7) Second time of deposition: A time period is 900 s, a temperature is set to 850 to 880 °C, a large nitrogen flow rate is 14.4 L/min, and a small nitrogen flow rate is 1.8 L/min, and an oxygen flow rate is 1.8 L/min.

(8) Second time of push: A time period is 1200 s, a temperature is set to 850 to 880 °C, a large nitrogen flow rate is 18 L/min, and a small nitrogen flow rate is 0 L/min, and an oxygen flow rate is 0 L/min.

(9) Post-oxidation and temperature reduction: A time period is 1800 s, a temperature is set to 780 to 800 °C, a large nitrogen flow rate is 14 L/min, and a small nitrogen flow rate is 0 L/min, and an oxygen flow rate is 4 L/min.

(10) Boat unloading: A time period is 510 s, a temperature is set to 780 °C, a large nitrogen flow rate is 9 L/min, small nitrogen and oxygen flow rates are 0 L/min, and a boat unloading speed is 250 mm/min.

(11) End: A time period is 10 s, a temperature is set to 780 °C, a large nitrogen flow rate is 9 L/min, and small nitrogen and oxygen flow rates are both 0 L/min.

(12) Cooling: The foregoing silicon wafer is allowed to cool to room temperature, to obtain a required gettered silicon wafer.

Comparative example 1

By using the method exactly the same as that in example 1, only the antimony-containing dopant used in example 1 was replaced with a phosphorus-doped master alloy as a dopant, and the rest remains unchanged, to prepare a gettered silicon wafer.

Comparative example 2

By using the method exactly the same as that in comparative example 1, only the amount of the dopant used in comparative example 1 was changed, and the rest remains unchanged, to prepare a gettered silicon wafer.

Comparative example 3

By using the method exactly the same as that in comparative example 1, only the amount of the dopant used in comparative example 1 was changed, and the rest remains unchanged, to prepare a gettered silicon wafer.

Comparative example 4

By using the method exactly the same as that in comparative example 1, only the amount of the dopant used in comparative example 1 was changed, and the rest remains unchanged, to prepare a gettered silicon wafer.

Comparative example 5

By using the method exactly the same as that in comparative example 1, only the amount of the dopant used in comparative example 1 was changed, and the rest remains unchanged, to prepare a gettered silicon wafer.

Examples 2 to 5

By using the method exactly the same as that in example 1, only the antimony content of the antimony-containing dopant used in example 1 was adjusted, the rest remains unchanged, to prepare a non-gettered silicon wafer, and the gettered silicon wafer was obtained by using a gettering method the same as that in example 1.

Concentrations of phosphorus or antimony and resistivities of the silicon wafer before and after gettering in examples 1 to 5 and comparative examples 1 to 5 are detected by using an ICP-MS method and a four-probe tester, and mechanical strengths and dispersion degrees of the mechanical strengths of the silicon wafer of examples 1 to 5 and comparative examples 1 to 5 are also detected based on a fine ceramics bending strength test method GB/T 6569-2006 and a single-column electronic universal testing machine. The results are shown in Table 1. Data of the concentration of phosphorus or antimony, the resistivity, the mechanical strength, and the dispersion degree of the mechanical strengths of the silicon wafer before and after gettering is the same. Table 1 shows the data of the concentration of phosphorus or antimony, the resistivity, the mechanical strength, and the dispersion degree of the mechanical strength of the silicon wafer after gettering.

In the fine ceramics bending strength test method GB/T 6569-2006, the bending strength refers to the maximum stress of a material when the material breaks under a bending load condition, and a calculation formula of the bending strength of three-point bending is as follows:

$$\sigma\tau = \frac{3FL}{2bd^2}$$

In the formula:

$\sigma\tau$ is the bending strength in a unit of megapascal (MPa);
F is a maximum load in a unit of Newton (N);
a is a length of a bending moment arm to which a sample is subject in a unit of millimeter (mm);
b is a width of the sample in a unit of millimeter (mm);
d is a thickness of the sample in a unit of millimeter (mm); and
L is a span in a unit of millimeter (mm).

When a strength test is performed, a level detection platform is set, and two support beams are mounted on the level detection platform. A cell is placed on the two support beams, a span between the two support beams is 60 mm, a size of the silicon wafer is 182 cm * 183.75 cm, and a thickness of the silicon wafer ranges from 40 $\mu$m to 170 $\mu$m. Then, push force is applied to the silicon wafer from top to bottom. Specific data of the applied pressure and a push distance are recorded by using a sensor, so as to measure a mechanical strength of the silicon wafer.

Table 1: Parameters of examples 1 to 5 and comparative examples 1 to 5

|  | Concentration of a phosphorus or antimony element in the silicon wafer (atom·cm⁻³) | Resistivity of the silicon wafer ($\Omega\cdot$cm) | Maximum fracture force (N) | Mechanical strength (MPa) | Dispersion degree of mechanical strengths |
|---|---|---|---|---|---|
| Comparative example 1 | 8.48E+15 | 0.6 | 8.97 | 226.31 | 1.20 |
| Comparative example 2 | 6.19E+15 | 0.8 | 9.03 | 227.83 | 1.16 |
| Comparative example 3 | 4.86E+ 15 | 1 | 8.62 | 217.48 | 1.25 |
| Comparative example 4 | 3.68E+ 15 | 1.3 | 8.87 | 223.79 | 1.22 |
| Comparative example 5 | 3.16E+ 15 | 1.5 | 8.77 | 221.27 | 1.29 |

(continued)

| | Concentration of a phosphorus or antimony element in the silicon wafer (atom·cm^{-3}) | Resistivity of the silicon wafer (Ω·cm) | Maximum fracture force (N) | Mechanical strength (MPa) | Dispersion degree of mechanical strengths |
|---|---|---|---|---|---|
| Example 1 | 8.48E+15 | 0.6 | 12.19 | 307.55 | 0.68 |
| Example 2 | 6.19E+15 | 0.8 | 12.10 | 305.28 | 0.74 |
| Example 3 | 4.86E+15 | 1 | 11.85 | 298.97 | 0.82 |
| Example 4 | 3.68E+15 | 1.3 | 11.63 | 293.42 | 0.86 |
| Example 5 | 3.16E+15 | 1.5 | 11.07 | 279.29 | 0.87 |

As described above, in comparative examples 1 to 5 and examples 1 to 5, the same gettering process treatment was performed on each of the phosphorus-doped silicon wafer and the antimony-doped silicon wafer that have the same resistance, and minority carrier lifetimes of the silicon wafers before and after gettering in comparative examples 1 to 5 and examples 1 to 5 were tested by using a WCT-120 instrument (parameters corresponding to the silicon wafers are inputted, and a 3E15 injection concentration is selected for tests), and were compared. Specific values are shown in the following Table 2. It can be seen that after gettering, the antimony-doped silicon wafer has a more significant lifetime improving effect.

Lifetime data and resistivity data of the two silicon wafers before and after gettering in comparative examples 1 to 5 and examples 1 to 5 were brought into a formula (4) of this application, to solve relative impurity levels of the two silicon wafers before and after gettering. Specific values are shown in Table 2. The results show that more impurities can be removed from the antimony-doped silicon wafer through gettering. It was theoretically proved that the antimony-doped silicon wafer has a function of suppressing impurity generation.

Table 2

| | | Resistivity (Ω·cm) | Lifetime (μs) before gettering | Relative impurity level (calculated value) before gettering | Lifetime (μs) after gettering | Relative impurity level (calculated value) after gettering | Lifetime lifting amplitude |
|---|---|---|---|---|---|---|---|
| Phosphorus-doped single crystal | Comparative example 1 | 0.6 | 1560 | 2.254e-02 | 1870 | 1.881e-02 | 19.87% |
| | Comparative example 2 | 0.8 | 3520 | 1.253e-02 | 4100 | 1.076e-02 | 16.48% |
| | Comparative example 3 | 1 | 4530 | 1.141e-02 | 5120 | 1.010e-02 | 13.02% |
| | Comparative example 4 | 1.3 | 5387 | 1.134e-02 | 6037 | 1.012e-02 | 12.07% |
| | Comparative example 5 | 1.5 | 6902 | 9.605e-02 | 7849 | 8.446e-02 | 13.72% |
| Antimony-doped single crystal | Example 1 | 0.6 | 1570 | 2.240e-02 | 1970 | 1.785e-02 | 25.48% |
| | Example 2 | 0.8 | 3540 | 1.247e-02 | 4410 | 1.000e-02 | 24.58% |
| | Example 3 | 1 | 4440 | 1.132e-02 | 6283 | 8.003e-03 | 41.52% |
| | Example 4 | 1.3 | 5305 | 1.151e-02 | 6867 | 9.812e-03 | 29.44% |
| | Example 5 | 1.5 | 6700 | 9.895e-03 | 8180 | 8.105e-03 | 22.09% |

In the examples and the comparative examples, for a silicon wafer before and after gettering, a resistivity of the silicon wafer was detected by using a four-probe tester, a minority carrier lifetime was detected by using a WCT-120 device, parameters corresponding to the silicon wafer were inputted, a 3E15 injection concentration was selected for tests, and an antimony concentration was detected by using ICP-MS.

After being subject to the same gettering process, the antimony-doped silicon wafer can have more impurities gettered than the phosphorus-doped silicon wafer, thereby more effectively improving the quality of the silicon wafer, and after being prepared into a cell, has more significant advantages in terms of short-circuit current and open-circuit voltage than the phosphorus-doped silicon wafer.

Further, the gettered silicon wafers prepared in example 3 and comparative example 3 were subject to the following steps of polishing, cleaning and texturing, preparing a double-sided amorphous silicon doped layer and a TCO layer, screen printing of a motor and sintering, and optical injection and annealing, to prepare a cell, and a short-circuit current and an open-circuit voltage of the obtained cell were detected by using an IV tester. The results are shown in Table 3 and Table 4.

Table 3

| | | Resistivity ($\Omega\cdot$cm) | Short-circuit current (A) before gettering | Short-circuit current (A) after gettering | Short-circuit current lifting amplitude |
|---|---|---|---|---|---|
| Phosphorus-doped single crystal | Comparative example 3 | 1 | 6.518 | 6.52 | 0.03% |
| antimony-doped single crystal | Example 3 | 1 | 6.524 | 6.552 | 0.43% |

Table 4

| | | Resistivity ($\Omega\cdot$cm) | Open-circuit voltage (V) before gettering | Open-circuit voltage (V) after gettering | Open-circuit voltage lifting amplitude |
|---|---|---|---|---|---|
| Phosphorus-doped single crystal | Comparative example 3 | 1 | 0.7486 | 0.7490 | 0.05% |
| Antimony-doped single crystal | Example 3 | 1 | 0.7450 | 0.7462 | 0.16% |

The foregoing described apparatus embodiments are merely examples. The units described as separate parts may or may not be physically separate, and the parts displayed as units may or may not be physical units, may be located in one position, or may be distributed on a plurality of network units. Some or all of the modules may be selected according to actual needs to achieve the objectives of the solutions of the embodiments. A person of ordinary skill in the art may understand and implement the embodiments of this application without creative efforts.

"One embodiment", "Embodiment", or "one or more embodiments" mentioned in this specification mean that particular features, structures, or characteristics described with reference to the embodiments may be included in at least one embodiment of this application. In addition, it should be noted that the phrase example herein of "in an embodiment" does not necessarily refer to a same embodiment.

Numerous specific details are set forth in the specification provided herein. However, it may be understood that, the embodiments of this application may be practiced without these specific details. In some examples, well-known methods, structures, and technologies are not shown in detail so as not to obscure the understanding of the specification.

In the claims, any reference sign between parentheses shall not be construed as limiting the claims. The word "include" does not exclude the presence of elements or steps not listed in the claims. A word "a" or "one" before an element does not exclude a plurality of such elements. This application may be implemented through hardware including different elements and a suitably programmed computer. In the unit claims enumerating several apparatuses, several of these apparatuses can be specifically embodied by the same item of hardware. The use of the words such as first, second, and third does not indicate any order. These words may be explained as names.

Finally, it should be noted that, the foregoing embodiments are merely used for describing the technical schemes of this application, but are not intended to limit this application. Although this application is described in detail with reference to the foregoing embodiments, it should be understood that a person of ordinary skill in the art may still make modifications to the technical schemes described in the foregoing embodiments or make equivalent replacements to some technical features thereof, without departing from the spirit and scope of the technical solutions of the embodiments of this application.

**Claims**

1. A silicon wafer, wherein a concentration of an antimony element in the silicon wafer ranges from 4E+14 $cm^{-3}$ to 2E+16 $cm^{-3}$, preferably ranges from 4.30E+14 $cm^{-3}$ to 1.9E+16 $cm^{-3}$, and further preferably ranges from 4.45E+14 $cm^{-3}$ to 1.87E+16 $cm^{-3}$; and
a minority carrier lifetime of the silicon wafer is greater than or equal to 200 $\mu$s, preferably greater than or equal to 300 $\mu$s, and further preferably greater than or equal to 500 $\mu$s.

2. The silicon wafer according to claim 1, wherein the minority carrier lifetime of the silicon wafer is greater than or equal to 1000 $\mu$s, preferably greater than or equal to 3000 $\mu$s, and further preferably greater than or equal to 5000 $\mu$s.

3. A silicon wafer, wherein the silicon wafer is obtained by performing gettering treatment on a silicon substrate containing an antimony element, and the gettering treatment is preferably tube-type gettering treatment or chain-type gettering treatment;

a concentration of an antimony element in the silicon wafer ranges from 4E+14 $cm^{-3}$ to 2E+16 $cm^{-3}$, preferably ranges from 4.30E+14 $cm^{-3}$ to 1.9E+16 $cm^{-3}$, and further preferably ranges from 4.45E+14 $cm^{-3}$ to 1.87E+16 $cm^{-3}$; and
a minority carrier lifetime of the silicon wafer is greater than or equal to 300 $\mu$s, preferably greater than or equal to 400 $\mu$s, and further preferably greater than or equal to 600 $\mu$s.

4. The silicon wafer according to claim 3, wherein the minority carrier lifetime of the silicon wafer is greater than or equal to 1200 $\mu$s, preferably greater than or equal to 3300 $\mu$s, and further preferably greater than or equal to 5500 $\mu$s.

5. The silicon wafer according to any one of claims 1 to 4, wherein a resistivity of the silicon wafer ranges from 0.3 to 10 $\Omega$·cm, preferably ranges from 0.4 to 8 $\Omega$·cm, and further preferably ranges from 0.5 to 6 $\Omega$·cm.

6. The silicon wafer according to any one of claims 1 to 5, wherein the silicon wafer further comprises at least one of phosphorus, gallium, and germanium.

7. The silicon wafer according to any one of claims 1 to 6, wherein a mechanical strength of the silicon wafer is greater than or equal to 70 MPa.

8. The silicon wafer according to any one of claims 1 to 7, wherein a side length of the silicon wafer is greater than 156 mm.

9. The silicon wafer according to any one of claims 1 to 8, wherein the silicon wafer is a rectangle, one side length of the rectangle ranges from 156 mm to 300 mm, and the other side length of the rectangle ranges from 83 to 300 mm.

10. The silicon wafer according to any one of claims 1 to 9, wherein the silicon wafer further comprises a chamfer connected between two adjacent sides of the silicon wafer, and a projection length of an arc length of the chamfer ranges from 1 mm to 10 mm.

11. The silicon wafer according to any one of claims 1 to 10, wherein a thickness of the silicon wafer ranges from 40 $\mu$m to 170 $\mu$m, preferably ranges from 70 $\mu$m to 160 $\mu$m, and further preferably ranges from 80 $\mu$m to 140 $\mu$m.

12. The silicon wafer according to claim 1, wherein the concentration of the antimony element in the silicon wafer and a relative impurity level in the silicon wafer satisfy the following formula (1):

$$\frac{n_0 + a}{\tau_{SRH} \times b \times (n_0 + c)} \le 5E-1 \quad (1)$$

wherein $n_0$ is the concentration of the antimony element in the silicon wafer in a unit of $cm^{-3}$, $\tau_{SRH}$ is the minority carrier lifetime of the silicon wafer in a unit of second, and a, b, and c are fitting parameters and have units of $cm^{-3}$, cm/s, and

cm$^{-3}$ respectively;

preferably, the concentration of the antimony element in the silicon wafer and a relative impurity level in the silicon wafer satisfy the following formula (2):

$$\frac{n_0 + a}{\tau_{SRH} \times b \times (n_0 + c)} \le 9E-2 \quad (2);$$

and further preferably, the concentration of the antimony element in the silicon wafer and a relative impurity level in the silicon wafer satisfy the following formula (3):

$$5E-5 \le \frac{n_0 + a}{\tau_{SRH} \times b \times (n_0 + c)} \le 6E-2 \quad (3);$$

wherein a is any value selected from 3.5E+18 to 5.5E+18, a is further preferably any value from 4E+18 to 5E+18, and a is further preferably 4.54E+18; b is any value selected from 0.8E+7 to 1.5E+7, b is further preferably any value from 0.9E+7 to 1.3E+7, and b is further preferably 1.1E+7; and c is any value selected from 1E+15 to 9E+15, c is further preferably any value from 1E+15 to 7E+15, and c is further preferably 3E+15.

13. The silicon wafer according to claim 3, wherein
the concentration of the antimony element in the silicon wafer and a relative impurity level in the silicon wafer satisfy the following formula (1'):

$$\frac{n_0 + a}{\tau_{SRH} \times b \times (n_0 + c)} \le 1E-1 \quad (1')$$

wherein $n_0$ is the concentration of the antimony element in the silicon wafer in a unit of cm$^{-3}$, $\tau_{SRH}$ is the minority carrier lifetime of the silicon wafer in a unit of second, and a, b, and c are fitting parameters and have units of cm$^{-3}$, cm/s, and cm$^{-3}$ respectively;

preferably, the concentration of the antimony element in the silicon wafer and a relative impurity level in the silicon wafer satisfy the following formula (2'):

$$\frac{n_0 + a}{\tau_{SRH} \times b \times (n_0 + c)} \le 8E-2 \quad (2');$$

and further preferably, the concentration of the antimony element in the silicon wafer and a relative impurity level in the silicon wafer satisfy the following formula (3'):

$$4E-5 \le \frac{n_0 + a}{\tau_{SRH} \times b \times (n_0 + c)} \le 5E-2 \quad (3').$$

14. A cell, comprising the silicon wafer according to any one of claims 1 to 13.

15. The cell according to claim 14, wherein a thickness of the cell ranges from 40 $\mu$m to 170 $\mu$m, preferably ranges from 70 $\mu$m to 160 $\mu$m, and further preferably ranges from 80 $\mu$m to 140 $\mu$m.

16. The cell according to claim 14 or 15, wherein one side length of the cell ranges from 156 mm to 300 mm, and the other side length of the cell ranges from 83 to 300 mm.

17. The cell according to any one of claims 14 to 16, wherein the cell comprises a silicon substrate, and a resistivity of the silicon substrate ranges from 0.3 to 10 $\Omega \cdot$cm, preferably ranges from 0.4 to 8 $\Omega \cdot$cm, and further preferably ranges from 0.5 to 6 $\Omega \cdot$cm.

18. The cell according to any one of claims 14 to 17, wherein a mechanical strength of the cell is greater than or equal to 50 MPa, preferably greater than or equal to 60 MPa, and preferably greater than or equal to 70 MPa.

19. A cell, comprising a silicon substrate, wherein a doped region is provided inside a surface of at least one side of the silicon substrate, the silicon substrate contains an antimony element, the doped region is doped with a doping element, and the doping element is selected from Group IIIA elements or Group VA elements;

a doping concentration of the antimony element in the silicon substrate ranges from $4E+14$ cm$^{-3}$ to $2E+16$ cm$^{-3}$, preferably ranges from $4.3E+14$ cm$^{-3}$ to $1.9E+16$ cm$^{-3}$, and further preferably ranges from $4.45E+14$ cm$^{-3}$ to $1.87E+16$ cm$^{-3}$; and

a minority carrier lifetime of the silicon substrate is greater than or equal to 200 $\mu$s, preferably greater than or equal to 300 $\mu$s, and further preferably greater than or equal to 500 $\mu$s.

20. The cell according to claim 19, wherein a doped region is provided inside a surface of at least one side of the silicon substrate, or at least one doped passivation layer is provided on a surface of at least one side of the silicon substrate.

21. The cell according to claim 19, wherein the doping concentration of the antimony element in the doped region is substantially unchanged in a thickness direction of the silicon substrate.

22. The cell according to claim 19, wherein
in the doped region, a sum of the doping concentration of the antimony element and a doping concentration of the doping element is less than or equal to $1E+21$ cm$^{-3}$.

23. The cell according to claim 19, wherein

when the doping element is a Group IIIA element, a thickness range of the doped region is from 30 to 650 nm; or
when the doping element is a Group VA element, a thickness range of the doped region is from 100 to 200 nm.

24. The cell according to claim 19, wherein

the doped region comprises a first doped region and a second doped region;
an interfacial passivation layer and a doped passivation layer are sequentially stacked on a surface of a side of the first doped region away from the silicon substrate;
the doped passivation layer is doped with a first doping element;
the second doped region on the silicon substrate is further doped with a second doping element; and
a conduction type of the first doped region is opposite to that of the second doped region.

25. The cell according to claim 24, wherein

the first doping element is a Group VA element, and the second doping element is a Group IIIA element; and
in the doped passivation layer, a doping concentration of the first doping element at a first preset depth from the surface of the doped passivation layer away from the silicon substrate is greater than a doping concentration of the second doping element at an identical first preset depth from the surface of the second doped region, a thickness range of the doped passivation layer is from 100 to 400 nm, and the first preset depth is less than or equal to a thickness of the doped passivation layer.

26. The cell according to claim 24, wherein

the first doping element is a Group VA element, and the second doping element is a Group VA element; and
an interfacial passivation layer and a doped passivation layer are sequentially stacked on a surface of a side of the second doped region away from the silicon substrate; and
in the doped passivation layer, a doping concentration of the first doping element at a first preset depth from the surface of the doped passivation layer away from the silicon substrate in the first doped region is greater than a doping concentration of the second doping element at an identical first preset depth from the surface of the doped passivation layer away from the silicon substrate in the second doped region, a thickness range of the doped passivation layer on the first doped region is from 100 to 400 nm, a thickness range of the doped passivation layer on the second doped region is from 100 to 400 nm, and the first preset depth is less than or equal to a thickness of the doped passivation layer on the first doped region.

**27.** The cell according to claim 25, wherein

the interfacial passivation layer is doped with a first doping element; and

in a direction from the doped passivation layer to the interfacial passivation layer, in the interfacial passivation layer, a doping concentration of the first doping element at a second preset depth from the surface of the doped passivation layer away from the silicon substrate is greater than a doping concentration of the second doping element at an identical second preset depth from the surface of the second doped region, a thickness range of the interfacial passivation layer is from 0.5 to 3 nm, and the second preset depth is less than or equal to a sum of thicknesses of the doped passivation layer and the interfacial passivation layer.

**28.** The cell according to claim 26, wherein

the interfacial passivation layer of the first doped region is doped with a first doping element, and the interfacial passivation layer of the second doped region is doped with a second doping element; and

in a direction from the doped passivation layer to the interfacial passivation layer, in the interfacial passivation layer, a doping concentration of the first doping element at a second preset depth from the surface of the doped passivation layer away from the silicon substrate in the first doped region is greater than a doping concentration of the second doping element at an identical second preset depth from the surface of the doped passivation layer away from a silicon matrix in the second doped region, a thickness range of the interfacial passivation layer on the first doped region is from 0.5 to 3 nm, a thickness range of the interfacial passivation layer on the second doped region is from 0.5 to 3 nm, and the second preset depth is less than or equal to a sum of thicknesses of the doped passivation layer and the interfacial passivation layer on the first doped region.

**29.** The cell according to claim 25, wherein in a direction from the doped passivation layer to a surface of the first doped region, in the silicon substrate, a doping concentration of the first doping element at a third preset depth from the surface of the doped passivation layer away from a silicon matrix is greater than a doping concentration of the second doping element at an identical third preset depth from the surface of the second doped region, a thickness range of the first doped region is from 30 to 100 nm, and the third preset depth is less than or equal to a sum of thicknesses of the doped passivation layer, the interfacial passivation layer, and the first doped region.

**30.** The cell according to claim 26, wherein in a direction from the doped passivation layer to a surface of the first doped region, in a silicon matrix, a doping concentration of the first doping element at a third preset depth from the surface of the doped passivation layer away from the silicon substrate in the first doped region is greater than a doping concentration of the second doping element at an identical third preset depth from the surface of the doped passivation layer away from the silicon matrix in the second doped region, a thickness range of the first doped region is from 30 to 100 nm, and the third preset depth is less than or equal to a sum of thicknesses of the doped passivation layer and the interfacial passivation layer on the first doped region, and the first doped region.

**31.** The cell according to claim 28, wherein

when the doping element is a Group IIIA element, a thickness range of the doped region is from 80 to 180 nm; or when the doping element is a Group VA element, a thickness range of the doped region is from 30 to 100 nm.

**32.** The cell according to any one of claims 19 to 31, wherein the cell comprises an electrode formed on a light absorbing body, the electrode comprises a metallic crystal part in contact with the light absorbing body, and the metallic crystal part comprises the antimony element, wherein the light absorbing body comprises the silicon substrate and a region for separating carriers generated by the silicon substrate.

**33.** The cell according to claim 32, wherein the metallic crystal part further comprises a doping element, and a doping concentration of the doping element is greater than a doping concentration of the antimony element.

**34.** The cell according to any one of claims 19 to 33, wherein a thickness of the cell ranges from 40 μm to 170 μm, preferably ranges from 70 μm to 160 μm, and further preferably ranges from 80 μm to 140 μm.

**35.** The cell according to any one of claims 19 to 34, wherein one side length of the cell ranges from 156 mm to 300 mm, and the other side length of the cell ranges from 83 to 300 mm.

36. The cell according to any one of claims 19 to 35, wherein a resistivity of the silicon substrate ranges from 0.3 to 10 Ω·cm, preferably ranges from 0.4 to 8 Ω·cm, and further preferably ranges from 0.5 to 6 Ω·cm.

37. The cell according to any one of claims 19 to 36, wherein a mechanical strength of the cell is greater than or equal to 50 MPa, preferably greater than or equal to 60 MPa, and preferably greater than or equal to 70 MPa.

38. A cell string, comprising a plurality of cells connected to each other by using a conductive interconnection member, wherein at least one of the cells is the cell according to any one of claims 19 to 37.

39. The cell string according to claim 38, wherein a curvature of the cell is less than or equal to 2 mm.

40. The cell string according to claim 39, wherein the conductive interconnection member is a connection wire, or a conductive trace in a conductive back sheet, and the connection wire is attached to the cell through soldering or conductive bonding.

41. The cell string according to claim 40, wherein the soldering comprises a heating step.

42. The cell string according to claim 41, wherein a temperature interval of the heating step ranges from 100 to 160 degrees Celsius, and the curvature of the cell is less than or equal to 1.5 mm.

43. The cell string according to claim 42, wherein a temperature interval of the heating step ranges from 165 to 200 degrees Celsius, and the curvature of the cell is less than or equal to 2 mm.

44. The cell string according to any one of claims 38 to 43, wherein the conductive interconnection member comprises an electric contact part in contact with an electrode of the cell, and the electric contact part comprises the antimony element.

45. A solar module, comprising a plurality of cells, an encapsulation layer, a cover, and a back sheet, wherein the plurality of cells are sealed in the encapsulation layer, and the encapsulation layer is located between the cover and the back sheet; and each of the cells is the cell according to any one of claims 19 to 38.

46. The solar module according to claim 45, wherein a curvature of the cell is less than or equal to 1.2 mm.

47. The solar module according to claim 45, wherein the cell protrudes toward the cover to form a curved shape.

48. The solar module according to any one of claims 45 to 47, further comprising a frame, wherein an edge of the cover and/or the back sheet is embedded in a mounting part of the frame.

49. The solar module according to any one of claims 45 to 47, wherein the cover and/or the back sheet is a transparent sheet.

50. The solar module according to any one of claims 45 to 47, wherein the back sheet is a non-transparent sheet.

51. The solar module according to any one of claims 45 to 50, wherein the plurality of cells are connected to each other by using a conductive interconnection member, the conductive interconnection member comprises an electric contact part in contact with an electrode of the cell, and the electric contact part comprises the antimony element.

FIG. 1

FIG. 2

FIG. 3

Solar module

FIG. 4

Solar module

FIG. 5

FIG. 6

**EP 4 656 779 A1**

## INTERNATIONAL SEARCH REPORT

| International application No. |
|---|
| **PCT/CN2024/078449** |

| A. | CLASSIFICATION OF SUBJECT MATTER |
|---|---|

C30B29/06(2006.01)i;  C30B15/00(2006.01)i

According to International Patent Classification (IPC) or to both national classification and IPC

| B. | FIELDS SEARCHED |
|---|---|

Minimum documentation searched (classification system followed by classification symbols)

IPC:  C30B

Documentation searched other than minimum documentation to the extent that such documents are included in the fields searched

Electronic data base consulted during the international search (name of data base and, where practicable, search terms used)

CNABS, CNTXT, CNKI, VEN, DWPI, ENTXT, ISI Web of Science: 硅片, 硅, 衬底, 基底, 基片, 晶片, 晶圆, 锑, 浓度, 密度, 含量, 电阻, 少子寿命, 吸杂, 单晶, 隆基, Si, silicon, wafer?, substrate?, Sb, antimony, stibium, stibonium, antimonium, dop+, content?, concentration?, density?, ppm+, cm3, cm-3, single crystal+, unit crystal+, mono?crystal+, monocrystal+

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 112310233 A (LONGI SOLAR TECHNOLOGY (TAIZHOU) CO., LTD.) 02 February 2021 (2021-02-02)<br>description, paragraph 39 | 1-2, 5-12, 14-51 |
| Y | CN 112310233 A (LONGI SOLAR TECHNOLOGY (TAIZHOU) CO., LTD.) 02 February 2021 (2021-02-02)<br>description, paragraph 39 | 3-4, 13 |
| X | CN 112310232 A (LONGI SOLAR TECHNOLOGY (TAIZHOU) CO., LTD.) 02 February 2021 (2021-02-02)<br>description, paragraph 46 | 1-2, 5-12, 14-51 |
| Y | CN 112310232 A (LONGI SOLAR TECHNOLOGY (TAIZHOU) CO., LTD.) 02 February 2021 (2021-02-02)<br>description, paragraph 46 | 3-4, 13 |
| Y | CN 112289895 A (CHANGZHOU SHICHUANG ENERGY CO., LTD.) 29 January 2021 (2021-01-29)<br>description, paragraphs 21 and 27 | 3-4, 13 |

☑ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **29 May 2024** | **31 May 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**EP 4 656 779 A1**

**INTERNATIONAL SEARCH REPORT**

International application No.

**PCT/CN2024/078449**

**C. DOCUMENTS CONSIDERED TO BE RELEVANT**

| Category* | Citation of document, with indication, where appropriate, of the relevant passages | Relevant to claim No. |
|---|---|---|
| A | CN 111952417 A (JINKO SOLAR (SHANGHAI) MANAGEMENT CO., LTD. et al.) 17 November 2020 (2020-11-17)<br>entire document | 1-51 |
| A | CN 102828243 A (XI'AN LONGI SILICON MATERIALS CORP. et al.) 19 December 2012 (2012-12-19)<br>entire document | 1-51 |
| A | CN 1422988 A (ZHEJIANG UNIVERSITY) 11 June 2003 (2003-06-11)<br>entire document | 1-51 |
| A | CN 110536980 A (SUMCO CORP.) 03 December 2019 (2019-12-03)<br>entire document | 1-51 |

Form PCT/ISA/210 (second sheet) (July 2022)

**INTERNATIONAL SEARCH REPORT**
Information on patent family members

International application No.

**PCT/CN2024/078449**

| Patent document cited in search report | | | Publication date (day/month/year) | Patent family member(s) | | | Publication date (day/month/year) |
|---|---|---|---|---|---|---|---|
| CN | 112310233 | A | 02 February 2021 | CN | 112310233 | B | 14 June 2022 |
| CN | 112310232 | A | 02 February 2021 | CN | 112310232 | B | 24 March 2023 |
| CN | 112289895 | A | 29 January 2021 | CN | 112289895 | B | 27 July 2021 |
| | | | | WO | 2022142475 | A1 | 07 July 2022 |
| CN | 111952417 | A | 17 November 2020 | US | 2022059719 | A1 | 24 February 2022 |
| | | | | US | 11264529 | B1 | 01 March 2022 |
| | | | | US | 2022140178 | A1 | 05 May 2022 |
| | | | | US | 11721783 | B1 | 08 August 2023 |
| | | | | EP | 3961728 | A1 | 02 March 2022 |
| CN | 102828243 | A | 19 December 2012 | CN | 102828243 | B | 18 March 2015 |
| CN | 1422988 | A | 11 June 2003 | CN | 1190525 | C | 23 February 2005 |
| CN | 110536980 | A | 03 December 2019 | DE | 112018001044 | T5 | 28 November 2019 |
| | | | | KR | 20190109489 | A | 25 September 2019 |
| | | | | KR | 102253579 | B1 | 18 May 2021 |
| | | | | JPWO | 2018159108 | A1 | 27 June 2019 |
| | | | | JP | 6699797 | B2 | 27 May 2020 |
| | | | | US | 2019352796 | A1 | 21 November 2019 |
| | | | | US | 11078595 | B2 | 03 August 2021 |
| | | | | WO | 2018159108 | A1 | 07 September 2018 |
| | | | | CN | 110536980 | B | 29 June 2021 |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310158796
- CN 202311270249X

- GB T65692006 A